(19) Europäisches Patentamt
European Patent Office
Office européen des brevets

(11) Publication number: **0 134 669**
**B1**

(12) **EUROPEAN PATENT SPECIFICATION**

(45) Date of publication of patent specification: **27.04.88**

(51) Int. Cl.[4]: **H 01 L 27/14,** H 01 L 31/18

(21) Application number: **84304808.3**

(22) Date of filing: **13.07.84**

(54) **Photoelectric conversion device and its manufacturing method.**

(30) Priority: **13.07.83 JP 128270/83**
**31.10.83 JP 204441/83**
**26.03.84 JP 57713/84**

(43) Date of publication of application:
**20.03.85 Bulletin 85/12**

(45) Publication of the grant of the patent:
**27.04.88 Bulletin 88/17**

(84) Designated Contracting States:
**DE FR IT**

(56) References cited:
**EP-A-0 111 402**
**WO-A-83/00409**
**GB-A-2 080 621**
**US-A-4 281 208**
**US-A-4 292 092**
**US-A-4 316 049**

(73) Proprietor: **SEMICONDUCTOR ENERGY LABORATORY CO., LTD.**
**21-21 Kitakarasuyama 7-chome**
**Setagaya-ku Tokyo 157 (JP)**

(72) Inventor: **Yamazaki, Shunpei Semiconductor Energy Co, Ltd**
**21-21 Kitakarasuyama 7-chome**
**Setagaya-ku Tokyo (JP)**

(74) Representative: **Wright, Peter David John et al**
**R.G.C. Jenkins & Co. 26 Caxton Street**
**London SW1H 0RJ (GB)**

**EP 0 134 669 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to improvements in a photoelectric conversion device which comprises a plurality of series-connected semiconductor transducers and in its manufacturing method.

A photoelectric conversion device comprising a plurality of series-connected semiconductor transducers $U_1$, $U_2$, ..., has been proposed which comprises a substrate having an insulating surface, a plurality of first electrodes $E_1$, $E_2$, ... formed in side-by-side sequential relationship on the substrate, a non-single-crystal semiconductor laminate member formed on the substrate to cover the first electrodes $E_1$, $E_2$, ..., and a plurality of second electrodes $F_1$, $F_2$, ... formed in side-by-side relationship on the non-single-crystal semiconductor layer in opposing relation to the first electrodes $E_1$, $E_2$, ..., respectively, and in which the semiconductor transducer $U_i$ (where i=1, 2, ...) is constituted by the first electrode $E_i$, the second electrode $F_i$ and that region $Q_i$ of the non-single-crystal semiconductor laminate member which is sandwiched between the first and second electrodes $E_i$ and $F_i$, the second electrode $F_i$ being connected to the first electrode $E_{i+1}$ through a contact portion $K_{i(i+1)}$.

In one such conventional photoelectric conversion device which is described in US—A—4 281 208, the contact portion $K_{i(i+1)}$ which interconnects the second electrode $F_i$ of the semiconductor transducer $U_i$ and the first electrode $E_{i+1}$ of the semiconductor transducer $U_{i+1}$ is comprised by an extension of the first electrode $E_{i+1}$ onto a side surface of the substrate which extends in the direction of the serial arrangement of the semiconductor transducers $U_1$, $U_2$, ..., and an extension of the second electrode $F_i$ onto that side wall of the non-single-crystal semiconductor laminate member which extends in the direction of the serial arrangement of the semiconductor transducers $U_1$, $U_2$, ... and thence onto the substrate side surface and into contact with the extension of the first electrode $E_{i+1}$. In such an arrangement, the contact portion $K_{i(i+1)}$ is complex in construction and there is a certain limit to decreasing the area occupied by the contact portion on the substrate. Accordingly, it is difficult to fabricate this conventional photoelectric conversion device with a simple construction and with a high density.

Further, in conventional photoelectric conversion devices of the above construction, when forming the second electrode $F_i$ which has the extension forming the contact portion $K_{i(i+1)}$, together with the extension of the first electrode $E_{i+1}$, there is a risk of shorting the first and second electrodes $E_i$ and $F_i$ of the semi-conductor transducer $U_i$ by the material forming the second electrode $F_i$. On account of this, it is difficult to obtain photoelectric conversion devices with the required high photoelectric conversion efficiency.

In another such conventional photoelectric conversion device which is described in GB—A—2 080 621, the contact portion $K_{i(i+1)}$ which interconnects the second electrode $F_i$ of the semiconductor transducer $U_i$ and the first electrode $E_{i+1}$ of the semiconductor transducer $U_{i+1}$ is formed as an extension downwards towards the substrate of the second electrode $F_i$, the electrodes $F_i$ and $E_{i+1}$ which are to be interconnected being formed so as to overlap slightly in the direction of the serial arrangement of the semiconductor transducers $U_1$, $U_2$, ... and the contact portion $K_{i(i+1)}$ extending downwardly from the front edge of the second electrode $F_i$, through a groove scribed in the semiconductor laminate member, and into contact with the rear edge of the first electrode $E_{i+1}$. Whilst such a device as is described in GB—A—2 080 621 can be manufactured with more efficient utilization of the substrate surface since areas thereof do not have to be set aside for the contact portion $K_{i(i+1)}$, nonetheless this device, in common with the device of US—A—4 281 208 abovementioned, suffers from the disadvantage that, since there is a risk that a non-negligible leakage current might flow between the first and second electrodes $E_i$ and $F_i$ of the semiconductor transducer $U_i$ via the side wall of the region $Q_i$ of the non-single-crystal semiconductor laminate member extending along the direction of serial arrangement of the semiconductor transducers $U_1$, $U_2$, ..., therefore there is a likelihood that such conventional photoelectric conversion devices cannot be operated with the required high photoelectric conversion efficiency.

Various methods have been proposed for the manufacture of the abovesaid photoelectric conversion devices. However, the prior art methods do not allow ready manufacture of a closely-packed photoelectric conversion device of low leakage current and with the required high photoelectric conversion efficiency.

It is therefore an object of the present invention to provide an improved photoelectric conversion device which can be easily manufactured without the risk of incurring the abovesaid defects, and an improved method for the manufacture of such an improved photoelectric conversion device.

According to one aspect of the present invention there is provided a photoelectric conversion device comprising a plurality of series-connected semiconductor transducers constituted by a non-single-crystal semiconductor lamina having side walls which extend in the direction of the serial arrangement of the semiconductor transducers and a plurality of spaced-apart first electrodes on one surface thereof in generally opposing relationship with a plurality of spaced-apart second electrodes on the opposite surface of the lamina, each of said electrodes having a major portion in opposing relation with a major portion of a respective one of the electrodes on the other side of the lamina and a minor portion in opposing relation with a minor portion of the next adjacent one of the electrodes on the other side of the lamina and connections being provided between the opposed minor portions of the electrodes on opposite sides of the lamina, as known for example from GB—A—2 080 621, the said device being characterized in accordance with the invention in that said connections are provided through apertures in the lamina which do not extend to said side walls of the lamina.

More particularly, in accordance with an embodiment of the present invention there is provided a photoelectric conversion device which comprises a plurality of series-connected semiconductor transducers $U_1$, $U_2$, ..., comprising:

a substrate having an insulating surface;

a plurality of first electrodes $E_1$, $E_2$, ... formed in side-by-side sequential relationship on the substrate;

a non-single-crystal semiconductor laminate member formed on the substrate to cover the first electrodes $E_1$, $E_2$, ..., said semiconductor laminate member having side walls which extend in the direction of the serial arrangement of the semiconductor transducers $U_1$, $U_2$, ...; and

a plurality of second electrodes $F_1$, $F_2$, ... formed on the non-single-crystal semiconductor laminate member in opposing relation to the first electrodes $E_1$, $E_2$, ..., respectively;

and wherein:

the semiconductor transducer $U_i$ (where i=1, 2, ...) is constituted by the first electrode $E_i$, the second electrode $F_i$ and a region $Q_i$ of the non-single-crystal semiconductor laminate member which is sandwiched between the first and second electrodes $E_i$ and $F_i$;

the second electrode $F_i$ is connected to the first electrode $E_{i+1}$ through a contact portion $K_{i(i+1)}$;

the plurality of first electrodes $E_1$, $E_2$, ... are isolated from adjacent first electrodes by respective ones of a plurality of first isolation grooves $G_{12}$, $G_{23}$, ... sequentially arranged along the direction of arrangement of the first electrodes;

the non-single-crystal semiconductor laminate member extends into the plurality of first isolation grooves $G_{12}$, $G_{23}$, ...;

the plurality of second electrodes $F_1$, ... $F_2$, are isolated from adjacent second electrodes by respective ones of a plurality of second isolation grooves $H_{12}$, $H_{23}$, ... sequentially arranged along the direction of arrangement of the second electrodes;

the second isolation groove $H_{i(i+1)}$ extends in opposing relation to a region of the first electrode $E_{i+1}$ on one side of the isolation groove $G_{i(i+1)}$ and thereby the second electrode $F_i$ is opposite to said region of the first electrode $E_{i+1}$; and

in the region of the non-single-crystal semiconductor laminate member across which the second electrode $F_i$ is opposite to the first electrode $E_{i+1}$, there is provided a contact opening $O_{i(i+1)}$ which extends through the semiconductor laminate member between the second electrode $F_i$ and the first electrode $E_{i+1}$, the second electrode $F_i$ extending through the contact opening $O_{i(i+1)}$ to contact the first electrode $E_{i+1}$ and define the contact portion $K_{i(i+1)}$;

the foregoing features all being known from GB—A—2 080 621 and the device being characterized in accordance with the invention in that the contact opening $O_{i(i+1)}$ does not extend to said side walls of the non-single-crystal semiconductor laminate member, so that the contact portion $K_{i(i+1)}$ likewise does not extend to the said side walls of the non-single-crystal semiconductor laminate member either.

With such a photoelectric conversion device of the present invention, the contact portion $K_{i(i+1)}$, which interconnects the second electrode $F_i$ of the semiconductor transducer $U_i$ and the first electrode $E_{i+1}$ of the semiconductor transducer $U_{i+1}$, is simple-structured as compared with the contact portion in the conventional photoelectric conversion device of US—A—4 281 208, and the area of the substrate occupied by the contact portion $K_{i(i+1)}$ can be made far smaller than in this prior device. Therefore, the photoelectric conversion device of the present invention can be formed with a more simple construction and with a higher density than the aforementioned prior art device.

Furthermore, by virtue of the fact that the contact opening $O_{i(i+1)}$ and the contact portion $K_{i(i+1)}$ do not extend to the side walls of the non-single-crystal semiconductor laminate member, it is possible to effectively eliminate the possibility of the first electrode $E_i$ and the second electrode $F_i$ of the semiconductor transducer $U_1$ being shorted by the material forming the contact portion $K_{i(i+1)}$. This permits easy fabrication of photoelectric conversion devices of the required high photoelectric conversion efficiency.

Additionally, since the contact opening $O_{i(i+1)}$ and the contact portion $K_{i(i+1)}$ do not extend to the side walls of the non-single-crystal semiconductor laminate member, therefore, the possibility is reduced that a non-negligible leakage current might flow between the first and second electrodes $E_i$ and $F_i$ of the semiconductor transducer $U_i$ via the side walls of the region $Q_i$ of the semiconductor laminate member extending along the direction of the serial arrangement of the semiconductor transducers $U_1$, $U_2$, .... As a result a higher photoelectric conversion efficiency can be expected with photoelectric conversion devices manufactured in accordance with the present invention.

According to a preferred feature of the present invention, the side wall of the first electrode $E_i$ and/or the second electrode $F_i$ of the semiconductor transducer $U_i$, which extends along the direction of serial arrangement of the semiconductor transducers $U_i$, $U_2$, ..., is disposed within the corresponding side wall of the substrate with a spacing therefrom. With such an arrangement, it is possible to effectively prevent leakage current flow between the first and second electrodes $E_i$ and $F_i$ of the semiconductor transducer $U_i$ via the side wall of the region $Q_i$ of the non-single-crystal semiconductor laminate member which extends along the direction of serial arrangement of the semiconductor transducers $U_1$, $U_2$, .... Also it is possible to effectively avoid shorting of the first and second electrodes $E_i$ and $F_i$ by the material of either one or both of them. This ensures that the photoelectric conversion device operates with the required high photoelectric conversion efficiency without incurring any loss from the abovesaid leakage current. Furthermore, photoelectric conversion devices of the required high photoelectric conversion efficiency can easily be produced.

The present invention also extends to a method of manufacturing a photoelectric conversion device comprising a plurality of series connected semiconductor transducers $U_1$, $U_2$, ... each comprising a non-single-crystal semiconductor lamina member $Q_i$ (where i=1, 2, ...) sandwiched between a respective first electrode $E_i$ and a respective second electrode $F_i$, the method comprising forming a plurality of spaced-apart first electrodes $E_i$ on the surface of an insulating substrate, forming a layer of non-single-crystal semiconductor material on the substrate so as to overlie said plurality of first electrodes, said semiconductor material layer having side walls which extend in the direction of the serial arrangement of the semiconductor transducers $U_1$, $U_2$, ..., forming a plurality of contact openings $O_{i(i+1)}$ through said semiconductor material layer so as to provide access to said plurality of first electrodes adjacent one edge thereof, and forming a plurality of spaced-apart second electrodes $F_i$ on the surface of said semiconductor material layer so that each second electrode $F_i$ has a portion overlapping said edge of the next adjacent first electrodes $E_{i+1}$ and has a contact portion $K_{i(i+1)}$ which extends into the opening $O_{i(i+1)}$ and contacts the first electrode $E_{i+1}$, as known for example from GB—A—2 080 621, the said method being characterized in accordance with the invention in that the openings $O_{i(i+1)}$ do not extend to said side walls of the semiconductor material layer.

More particularly in accordance with an embodiment of the present invention there is provided a method of manufacturing a photoelectric conversion device which comprises a plurality of series-connected semiconductor transducers $U_1$, $U_2$, ..., said method comprising the steps of:

forming a first electrically conductive layer on a substrate having an insulating surface;

scribing the first electrically conductive layer by means of a laser beam so as to form therein a plurality of sequentially arranged first isolation grooves $G_{12}$, $G_{23}$, ... by virtue of which a plurality of sequentially arranged first electrodes $E_1$, $E_2$, ... are defined on the substrate,

forming a non-single-crystal semiconductor laminate member on the substrate so as to cover the plurality of first electrodes $E_1$, $E_2$, ... and to fill the plurality of first isolation grooves $G_{12}$, $G_{23}$, ..., said semiconductor laminate member having side walls which extend in the direction of the serial arrangement of the semiconductor transducers $U_1$, $U_2$, ...;

forming contact openings $O_{12}$, $O_{23}$, ... in the non-single-crystal semiconductor laminate member by use of a laser beam so as to expose respective regions of the first electrodes $E_2$, $E_3$, ... on one side of the first isolation grooves $G_{12}$, $G_{23}$, ..., respectively;

forming a second electrically conductive layer which covers the non-single-crystal semiconductor laminate member and extends into the contact openings $O_{12}$, $O_{23}$, ... to form contact portions $K_{12}$, $K_{23}$, ... in contact with the first electrodes $E_2$, $E_3$, ... respectively; and

scribing the second electrically conductive layer by means of a laser beam so as to form therein second isolation grooves $H_{12}$, $H_{23}$, ... which define on the non-single-crystal semiconductor laminate member second electrodes $F_1$, $F_2$, ... connected to respective ones of the first electrodes $E_2$, $E_3$, ... through respective ones of the contact portions $K_{12}$, $K_{23}$, ...;

the foregoing method steps all being known from GB—A—2 080 621 and the method being characterized in accordance with the invention in that the contact openings $O_{i(i+1)}$ (where i=1, 2, ...) are formed so as not to extend to said side walls of the non-single-crystal semiconductor laminate member.

According to a preferred feature of the manufacturing method of the present invention, in the step of scribing the first electrically conductive layer, there is cut in the first electrically conductive layer at least one further isolation groove which extends in the direction of the serial arrangement of the semiconductor transducers $U_1$, $U_2$, ... and/or in the step of scribing the second electrically conductive layer, there is cut in the second electrically conductive layer at least one further isolation groove which extends in the direction of the serial arrangement of the semiconductor transducers $U_1$, $U_2$, ....

Such a manufacturing method of the present invention as described above permits easy fabrication of the photoelectric conversion device which has the aforementioned arrangement and the aforesaid features.

Other objects, features and advantages of the present invention are set forth in the appended claims and will become more fully apparent from the following detailed description taken in conjunction with the accompanying drawings wherein:—

Figs. 1A, B and C are respectively a plan view schematically illustrating an embodiment of the photoelectric conversion device of the present invention, a sectional view taken on the line B—B and a sectional view taken on the line C—C in Fig. 1A;

Figs. 2, 3, 4, 5, 6, 7 and 8 are schematic diagrams showing a sequence of steps involved in the manufacture of the photoelectric conversion device of Fig. 1 in accordance with an embodiment of the manufacturing method of the present invention, Figs. 2A, 4A to 8A being plan views, Figs. 2B, 3, and 4B to 8B cross-sectional views and Fig. 8C a longitudinal view; and

Figs. 9A, B and C are respectively a plan view schematically illustrating another embodiment of the photoelectric conversion device of the present invention, a sectional view taken on the line B—B and a sectional view taken on the line C—C in Fig. 9A.

Referring first to Figs. 1A to C, a first embodiment of the photoelectric conversion device of the present invention will be described.

The photoelectric conversion device of the present invention shown in Figs. 1A to C is provided with, for example, four semiconductor transducers $U_1$ to $U_4$ which are sequentially connected in series, and has such an arrangement as follows:

The photoelectric conversion device has a substrate 1.

The substrate 1 has a surface 2 of an organic or inorganic insulator. As such a substrate 1, for example, a synthetic resin substrate can be used which is transparent or nontransparent. It is also possible to employ a ceramic substrate, a transparent glass substrate and a substrate which has an insulating film as of synthetic resin, a silicon oxide or the like, deposited on a stainless steel or metal plate.

The substrate 1 is rectangular-shaped.

On a main surface 2 of the substrate 1 there are formed side by side four first electrodes $E_1$ to $E_4$.

Each of the electrodes $E_1$ to $E_4$ has a thickness of 1μm or less.

The first electrode $E_i$ (i=1, 2 ...) may be formed as a transparent conductive layer. In this case, the substrate 1 is transparent. The first electrode $E_i$ may be constituted principally of a sublimable metallic oxide such as $SnO_2$, $In_2O_3$ or ITO (Indium-Tin oxide), or a sublimable metallic nonoxide such as a Si-Cr or Si-Ni alloy.

The first electrode $E_i$ may also be formed as a nontransparent conductive layer. In such a case, the substrate 1 need not be transparent. The nontransparent first electrode $E_i$ may be constituted principally of sublimable metal such as Cr, a Cr-Cu alloy (containing 0.1 to 50 wt% of Cu), Cr-Ag alloy (containing 0.1 to 50 wt% of Ag) or Cr-N alloy (containing 0.1 to 50 wt% of N), or a nonsublimable metal such as Al, Cu or Ag.

Further, the first electrode $E_i$ may also be a laminate member which comprises a transparent conductive layer constituted principally of the abovesaid sublimable metallic oxide or sublimable metallic non-oxide and a nontransparent or reflective conductive layer constituted principally of the abovesaid sublimable metal or nonsublimable metal. In this case, the nontransparent or reflective conductive layer is formed on the side of the substrate 1, and the substrate 1 need not be transparent.

The electrode $E_i$ is, for example, rectangular in shape and has a width of 5 to 40 mm, preferably 15 mm and a length slightly smaller than the length of the substrate 1.

The electrodes $E_i$ and $E_{i+1}$ are spaced apart by a groove $G_{i(i+1)}$ which is shown to extend in the vertical direction in Fig. 1A. The groove $G_{i(i+1)}$ is, for example, 40 μm wide.

On the main surface 2 of the substrate 1 there is formed on the opposite side from the electrode $E_3$ with respect to the electrode $E_4$ another electrode $E_e$ which is similar to the first electrode $E_i$ and is separated from the electrode $E_4$ by an isolation groove $G_{4e}$ similar to the abovesaid isolation groove $G_{i(i+1)}$.

Further, the substrate 1 has opposite side walls 3 and 3′ which extend along the direction of arrangement of the semiconductor transducers $U_1$, $U_2$, ..., and on the marginal portion of the main surface 2 of the substrate 1 on the side of the side wall 3 thereof, there are formed electrodes $C_1$, $C_2$, ... and $C_e$ which are similar to the electrodes $E_1$, $E_2$, ... and $E_e$ but separated therefrom by an isolation groove 5 similar to that $G_{i(i+1)}$ and extending in the direction of semiconductor transducers $U_1$, $U_2$, .... Likewise, there are formed on the marginal portion of the main surface 2 of the substrate 1 on the side of the side wall 3′ thereof electrodes $C_1'$, $C_2'$, ... and $C_e'$ which are similar to those $E_1$, $E_2$, ... and $E_e$ but separated therefreom by an isolation groove 5′ similar to that 5. The electrodes $C_i$ and $C_{i+1}$ are isolated by an extension of the isolation groove $G_{i(i+1)}$ in the direction of arrangement of the semiconductor transducers $U_1$, $U_2$, ..., and similarly, the electrodes $C_i'$ and $C_{i+1}'$ are isolated by the isolation groove $G_{i(i+1)}$. The electrodes $C_4$ and $C_e$, and $C_4'$ and $C_e'$ are isolated by the isolation groove $G_{4e}$.

The isolation grooves 5 and 5′ expose those side walls 6 and 6′ of the electrodes $E_i$ and $E_e$ which extend along the direction of arrangement of the semiconductor transducers $U_1$, $U_2$, ..., and consequently, these side walls 6 and 6′ are inside the side walls 3 and 3′ of the substrate 1, respectively.

A non-single-crystal semiconductor laminate member 11 is formed on the main surface 2 of the substrate 1 to cover the electrodes $E_1$, $E_2$, ... $E_e$, $C_1$, $C_2$, ... $C_e$ and $C_1'$, $C_2'$, ... $C_e'$ and to fill the isolation grooves $G_{12}$, $G_{23}$, ... $G_{4e}$, 5 and 5′.

The non-single-crystal semiconductor laminate member 11 also has a thickness of 1 μm or less.

The non-single-crystal semiconductor laminate member 11 has such a PN junction structure that a P-type non-single-crystal semiconductor layer and N-type non-single-crystal semiconductor layer are laminated one on the other in this order or in the reverse order, or such a PIN junction structure that a P-, I- and N-type non-single-crystal semiconductor layers are laminated one on another in this order or in the reverse order.

The non-single-crystal semiconductor laminate member 11 may be constituted mainly of a sublimable semiconductor such as Si, $Si_xGe_{1-4}$ (where 0<x<0.5), $Si_xC_{1-x}$ (where 0<x<1), $Si_3N_{n-x}$ (where 0<x<2) or $SiO_{2-x}$ (where 0<x<1), and the laminate member 11 has introduced therein hydrogen or a halogen as a dangling bond neutralizer.

On the non-single-crystal semiconductor laminate member 11 there are provided electrodes $F_1$, $F_2$,... which are sequentially arranged in opposing relation to the electrodes $E_1$, $E_2$, ..., respectively.

The electrode $F_i$ also has a thickness of 1 μm or less.

The electrode $F_i$ may be formed as a transparent conductive layer which is constituted principally of the sublimable metallic oxide or sublimable metallic nonoxide mentioned previously with regard to the electrodes $E_1$ to $E_4$. In this case, the substrate 1 need not be transparent.

The electrode $F_i$ may also be formed as a nontransparent conductive layer which is constituted principally of the aforesaid sublimable metal. In such a case, the substrate 1 is transparent.

Moreover, the electrode $F_i$ may also be formed as a laminate member which composed of a transparent conductive layer constituted mainly of the aforesaid sublimable metallic oxide or sublimable metallic non-oxide and a nontransparent or reflective conductive layer which is constituted mainly of the aforementioned sublimable or nonsublimable metal. In this case, the transparent conductive layer is formed on the side of the non-single-crystal semiconductor laminate member 11, and the substrate 1 is transparent.

The electrodes $F_1$, $F_2$, ... are separated from adjacent ones of them along the direction of their arrangement by isolation grooves $H_{12}$, $H_{23}$, ... which are similar to the aforementioned groove $G_{i(i+1)}$. In this case, the isolation groove $H_{i(i+1)}$ extends in opposing relation to the region of the electrode $E_{i+1}$ on the side of the isolation groove $G_{i+1}$. Accordingly, the electrode $F_i$ is opposite to the region of the electrode $E_{i+1}$ on the side of the isolation groove $G_{i(i+1)}$, but the electrode $F_4$ is opposite to the electrode $E_e$.

On the non-single-crystal semiconductor laminate member 11, there is provided on the side opposite from the electrode $F_2$ with respect to the electrode $F_1$ another electrode $F_e$ which is similar to that $F_i$ and is separated from the electrode $F_1$ by an isolation groove $H_{e1}$ similar to the abovesaid one $H_{i(i+1)}$.

Furthermore, there are mounted on the marginal portion of the non-single-crystal semiconductor laminate member 11 on the side of the side wall 3 of the substrate 1 electrodes $D_1$, $D_2$,... and $D_e$ which are similar to the electrodes $C_1$, $C_2$, ... and $C_e$ but separated therefrom by an isolation groove 12 similar to the abovesaid groove 5. Likewise, there are provided on the marginal portion of the non-single-crystal semiconductor laminate member 11 on the side of the side wall 3′ of the substrate 1 electrodes $D_1'$, $D_2'$, ... and $D_e'$ which are similar to the electrodes $C_1'$, $C_2'$, ... and $C_e'$ but separated therefrom by an isolation groove 12′ which extends in the same direction as does the above said groove 12. The electrodes $D_i$ and $D_{i+1}$ are isolated by an extension of the isolation groove $H_{i(i+1)}$ in the direction of arrangement of the semiconductor transducers $U_1$, $U_2$, ..., and similarly, the electrodes $D_i'$ and $D_{i1}'$ are isolated by the isolation groove $H_{i(i+1)}$. The electrodes $D_1$ and $D_e$, and $D_1'$ and $D_e'$ are isolated by the isolation groove $H_{e1}$.

The isolation grooves 12 and 12′ expose those side walls 13 and 13′ of the electrodes $H_1$, $H_2$ ... and $H_e$ which extend along the direction of arrangement of the semiconductor transducers $U_1$, $U_2$, ..., and consequently, these side walls 13 and 13′ are inside the side walls 3 and 3′ of the substrate 1, respectively.

In the region of the non-single-crystal semiconductor laminate member 11 which is sandwiched between the electrodes $F_i$ and $E_{i+1}$, there is formed a contact groove $O_{i(i+1)}$ which extends between them. Similarly, in the region of the non-single-crystal semiconductor laminate member 11 which is sandwiched between the electrodes $F_e$ and $E_1$, there is formed a contact groove $O_{e1}$ which extends between them. The electrodes $F_i$ and $F_e$ extend, as contact portions $K_{i(i+1)}$ and $K_{e1}$, through the contact portions $O_{i(i+1)}$ and $O_{e1}$ for contact with the electrodes $E_{i+1}$ and $E_1$ respectively.

The electrodes $E_i$ and $F_i$ and the region $Q_i$ of the non-single-crystal semiconductor laminate member 11 across which the electrodes $E_i$ and $F_i$ are opposite to each other constitute the semiconductor transducer $U_i$, which is connected in series to the semiconductor transducer $U_{i+1}$ through the contact portion $K_{i(i+1)}$.

On the substrate 1 is formed a protective film 14 which covers the electrodes $F_1$, $F_2$, ... $F_e$, $D_1$, $D_2$, ... $D_e$ and $D_1'$, $D_2'$, ... $D_e'$ and fills the isolation grooves $H_{12}$, $H_{23}$, ... $H_{e1}$. The protective film 14 may be formed of synthetic resin. When the substrate 1 is nontransparent, the protective film 14 is transparent, but when the former is transparent, the latter need not always be transparent.

With the photoelectric conversion device of such an arrangement according to the present invention, the contact portion $K_{i(i+1)}$ is simple in construction and the area of the substrate occupied by the contact portion can be decreased, as described previously.

As will become apparent from a description given later of an embodiment of the photoelectric conversion device manufacturing method of the present invention, since the contact portion $K_{i(i+1)}$ is entirely surrounded by the non-single-crystal semiconductor laminate member 11, it is possible to effectively eliminate the possibility of the electrodes $E_i$ and $F_i$ of the semiconductor transducers $U_i$ being shorted by the material of the contact portion $K_{i(i+1)}$ when the substrate assembly is severed along the direction of arrangement of the semiconductor transducers $U_1$, $U_2$, ... into individual photoelectric conversion devices.

Further, since the side walls 6, 6′ and 13, 13′ of the electrodes $E_i$ and $F_i$ of the semiconductor transducer $U_i$ are exposed in the isolation grooves 5, 5′ and 12, 12′, respectively, and are inside of the side walls 3 and 3′ of the substrate 1, no leakage current flows between the electrodes $E_i$ and $F_i$ through the side walls of the non-single-crystal semiconductor laminate member 11, and there is no fear of shorting of the electrodes $E_i$ and $F_i$ through the material of either of them even in the case of severing the substrate assembly into individual photoelectric conversion devices.

Accordingly, the photoelectric conversion device of the present invention, shown in Fig. 1, is able to achieve an intended high photoelectric conversion efficiency and can easily be manufactured with a high density.

Turning next to Figs. 2 to 8, an embodiment of the manufacturing method of the present invention will hereinafter be described as being applied to the manufacture of the photoelectric conversion device described above in connection with Fig. 1.

In Figs. 2 to 8, the parts corresponding to those in Fig. 1 are identified by the same reference numerals, and no detailed description will be repeated.

The manufacture starts with the preparation of the substrate 1 having the insulating surface 2 (Fig. 2).

Then a conductive layer 21 of the same material and structure as the electrode $E_i$ is formed by a known evaporation or CVD method on the surface 2 of the substrate 1 (Fig. 3).

Next, the conductive layer 21 is scribed by a laser beam to cut therein vertically a plurality of sets of isolation grooves $G_{12}$, $G_{23}$, $G_{34}$ and $G_{4e}$ of a width substantially equal to the diameter of the laser beam which are sequentially arranged in the lateral direction (Fig. 4). At the same time, the conductive layer 21 is scribed to cut therein laterally a plurality of pairs of isolation grooves 5 and 5′ of the same width as the isolation groove $G_{i(i+1)}$ which are sequentially arranged in the lateral direction. In other words, by patterning the conductive layer 21 with the laser beam, a plurality of sets of electrodes $E_1$ to $E_4$ and $E_e$ are formed in a matrix form on the substrate 1, and at the same time, pluralities of sets of electrodes $C_1$ to $C_4$ and $C_e$ and sets of electrodes $C_1'$ to $C_4'$ and $C_e'$ are formed in a matrix form.

In this case, the electrode $E_e$ of one of two laterally adjoining sets of the electrodes $E_1$ to $E_4$ and $E_e$ is connected to the electrode $E_1$ of the other set.

Further, the electrode $C_e$ of one of two laterally adjoining sets of electrodes $C_1$ to $C_4$ and $C_e$ is connected to the electrode $C_1$ of the other set, and in a similar fashion, the electrode $C_e'$ of one of two adjacent sets of electrodes $C_1'$ to $C_4'$ and $C_e'$ is connected to the electrode $C_1'$ of the other set.

Furthermore, two sets of electrodes $C_1$ to $C_4$ and $C_e$ and $C_1'$ to $C_4'$ and $C_e'$, which are adjacent to each other in the vertical direction, bear such a relation that the electrodes $C_1$ to $C_4$ and $C_e$ of the former set are connected to the electrodes $C_1'$ to $C_4'$ and $C_e'$ of the latter set, respectively.

The laser beam used in this case may be pulse laser beam that has a short wavelength of 600 nm or less, a spot diameter of 3 to 60 µm and width of 50 nano-second or less.

As the pulse laser beam, a pulse laser beam of a 530 nm or so wavelength can be used which is obtainable with a YAG laser. It is also possible to employ a pulse laser beam of a 193 nm or so (ArF), 248 nm or so (KrF), 308 nm or so (XeCl) or 315 nm or so (XeF) wavelength which is obtainable with an excimer laser, a laser beam of a 514.5 nm or so, 488 nm or so, 458 nm or so, 363 nm or so or 351 nm or so wavelength which is obtainable with an argon laser, or a laser beam of a 337 nm or so wavelength which is obtainable with a nitrogen laser.

Also it is possible to use a pulse laser beam of such a long wavelength as about 1060 nm which is obtainable with a YAG laser.

When the laser beam has such a short wavelength of 600 nm or less, the absorption coefficient of the electrode $E_i$ for the laser beam is more than 100 times larger than the absorption coefficient for a laser beam having a long wavelength of about 1060 nm which is obtainable with a YAG laser. Accordingly, the conductive layer 21 is effectively heated by the laser beam locally at the position of its irradiation. On the other hand, since the conductive layer 21 is as thin as 1 µm or less, it does not unnecessarily transfer therethrough heat resulting from the irradiation by the laser beam, namely, the heat generated in the conductive layer 21 does not unnecessarily escape therefrom to outside through the conductive layer 21 itself. Moreover, the substrate 1 has the insulating surface, and hence it also prevents that the heat generated in the conductive layer 21 unnecessarily escape therefrom to the outside through the substrate 1. Accordingly, the material of the conductive layer 21 is effectively sublimed at the position of irradiation by the laser beam. As a result of this, electrodes $E_i$ are neatly formed, along with the grooves. In this case, there are no possibilities that the material of the conductive layer 21, molten by the laser beam irradiation, is deposited on the marginal edges of the electrode $E_i$. Further, since the laser beam is effectively absorbed by the conductive layer 21 because of its short wavelength, it would not inflict on the substrate 1 unnecessary damages such as depressions and cracks. The effects described just above are prominent especially when the conductive layer 21 is a transparent conductive layer which is constituted principally of the aforementioned sublimable metallic oxide or sublimable metallic non-oxide, a nontransparent conductive layer which is constituted principally of the aforesaid sublimable metal, or a laminate member composed of such transparent and nontransparent conductive layers. Incidentally, even if the conductive layer 21 is a nontransparent conductive layer which is constituted principally of the aforementioned nonsublimable metal, or a laminate member comprised of the abovesaid transparent conductive layer and the nontransparent or reflective conductive layer which is constituted mainly of the aforementioned nonsublimable metal, the substrate 1 is not unnecessarily damaged because it has the surface of an insulator.

Next, a non-single-crystal semiconductor laminate member 11 is formed, by a known CVD, low-pressure CVD, plasma CVD or optical CVD method, on the substrate 1 so that it covers the

electrodes $E_1$ to $E_4$ and $E_e$, $C_1$ to $C_4$ and $C_e$, and $C_1'$ to $C_4'$ and $C_e'$ and extend into the grooves $G_{12}$, $G_{23}$, $G_{34}$ and $G_{4e}$, 5 and 5' (Fig. 5).

The non-single-crystal semiconductor layer 11 also has a thickness of 1 µm or less.

Next, the non-single-crystal semiconductor laminate member 11 is irradiated by a laser beam to cut therein in a matrix form a plurality of set of contact grooves $O_{e1}$, $O_{12}$, $O_{23}$ and $O_{34}$ of a width substantially equal to the diameter of the laser beam (Fig. 6).

In this case, the grooves $O_{e1}$, $O_{12}$, $O_{23}$ and $O_{34}$ are formed to expose electrodes $E_1$, $E_2$, $E_3$ and $E_4$. The digging contact grooves $O_{e1}$ and $O_{i(i+1)}$ in the non-single-crystal semiconductor layer 11 is effected through using the same laser beam as that for the formation of the electrodes $E_i$, $E_e$, $C_i$, $C_e$, $C_i'$ and $C_e'$. Therefore, no detailed description will be repeated.

When the laser beam used has such a short wavelength as 600 nm or less, the absorption coefficient of the non-single-crystal semiconductor laminate member 11 for the laser beam is also large as is the case with the aforementioned conductive layer 21. Therefore, the non-single-crystal semiconductor laminate member 11 is effectively heated at the position of irradiation by the laser beam as in the case of the aforementioned conductive layer 21. Further, since the non-single-crystal semiconductor laminate member 11 is as thin as 1 µm or less, it does not transfer laterally therethrough the heat generated therein preventing that the heat unnecessarily escapes from the laminate member 11 to the outside, as described previously. Moreover, the non-single-crystal semiconductor laminate member 11 is constituted principaly of the sublimable semiconductor, as referred to previously. This enables the contact grooves $O_{i(i+1)}$ and $O_{e1}$ to be formed neatly, and ensures to prevent that the material of non-single-crystal semiconductor layer 11, molten by the laser beam irradiation, is deposited on marginal edges of the contact grooves $O_{i(i+1)}$ and $O_{e1}$, and that the electrodes $E_i$ and $E_e$ are hollowed, by the laser beam to form therein a deep depression which may sometimes reach the substrate 1. Next, a conductive layer 41 is formed on the substrate 1 to cover the non-single-crystal semiconductor laminate member 11. The conductive layer 41 has contact portions $K_{e1}$, $K_{12}$, $K_{23}$ and $K_{34}$ which extend through the contact grooves $O_{e1}$, $O_{12}$, $O_{23}$ and $O_{34}$ and down to the electrodes $E_1$, $E_2$, $E_3$ and $E_4$ of the corresponding sets, respectively. The conductive layer 41 is of the same material and construction as those of the electrode $F_i$.

Next, the conductive layer 41 is scribed by a laser beam to cut therein vertically a plurality of sets of isolation grooves $H_{12}$, $H_{23}$, $H_{34}$ and $H_{4e}$ of a width substantially equal to the diameter of the laser beam which are sequentially arranged in the lateral direction (Fig. 8). At the same time, the conductive layer 41 is scribed to cut therein laterally a plurality of pairs of isolation grooves 12 and 12' of the same width as the isolation grooves $H_{i(i+1)}$ and $H_{4e}$ which are sequentially arranged in the lateral direction. In other words, by patterning the conductive layer 41 with the laser beam, a plurality of sets of electrodes $F_1$ to $F_4$ and $F_e$ are formed in a matrix form on the substrate 1, and at the same time, pluralities of sets of electrodes $D_1$ to $D_4$ and $D_e$ and sets of electrodes $D_1'$ to $D_4'$ and $D_e'$ are formed in a matrix form.

In this case, electrode $F_e$ of one of two laterally adjoining sets of the electrodes $F_1$ to $F_4$ and $F_e$ is connected to the electrode $E_e$ of the other set.

Further, the electrode $D_4$ of one of two laterally adjoining sets of electrodes $D_1$ to $D_4$ and $D_e$ is connected to the electrode $D_e$ of the other set, and in a similar fashion, the electrode $D_e'$ of one of two adjacent sets of electrodes $D_1'$ to $D_4'$ and $D_e'$ is connected to the electrode $C_e'$ of the other set.

Furthermore, two sets of electrodes $D_1$ to $D_4$ and $D_e$ and $D_1'$ to $D_4'$ and $D_e'$, which are adjacent to each other in the vertical direction, bear such a relation that the electrodes $D_1$ to $D_4$ and $D_e$ of the former set are connected to the electrodes $D_1'$ to $D_4'$ and $D_e'$ of the latter set, respectively.

The laser beam used for the patterning of the conductive layer 41 into the electrodes $F_i$ and $F_e$, $D_i$ and $D_e$, and $D_i'$ and $D_e'$ is the same as that for the formation of the $E_i$ and $E_e$, $C_i$ and $C_e$, and $C_i'$ and $C_e'$. Therefore, no detailed description will be repeated.

The absorption coefficient of the conductive layer 41 for such a laser beam of a 600 nm or less wavelength is large as described previously in connection with the conductive layers 21 and the non-single-crystal semiconductor layers 11. On the other hand, the conductive layer 41 is thin and its portion on the side of the non-single-crystal semiconductor layer 11 is constituted mainly of the sublimable metallic oxide, sublimable metallic nonoxide or sublimable metal, so that the electrodes $F_i$ and $F_e$, $D_i$ and $D_e$, and $D_i'$ and $D_e'$ are neatly formed, along with the grooves $H_{e1}$ and $H_{i(i+1)}$. That is to say, there is no possibilities that the underlying non-single-crystal semiconductor layers 11 are hollowed, by the laser beam, to form therein deep depression which may sometime reach the underlying electrodes $E_i$, and that the electrodes $F_i$ and $F_e$, $D_i$ and $D_e$, and $D_i'$ and $D_e'$ are exfoliated at their marginal edges. Next, the protective film 14 which covers the electrodes $F_i$ and $F_e$, $D_i$ and $D_e$, and $D_i'$ and $D_e'$ and extends into the grooves $H_i$ and $H_e$, is formed by a known method.

Next, the substrate assembly is cut as by a laser beam along laterally and vertically extending cutting lines $X_1$, $X_2$, ... and $Y_1$, $Y_2$ ... into a plurality of such photoelectric conversion device as described previously in respect of Fig. 1.

The cutting lines $Y_1$, $Y_2$, ... each pass through a position where the electrode $E_e$ of one set of electrodes $E_1$ to $E_4$ and $E_e$ and the electrode $E_1$ of another set of electrodes $E_1$ to $E_4$ and $E_e$ adjacent thereto in the lateral direction are interconnected and a position where the electrode $E_4$ of one set of electrodes $F_1$ to $F_4$ and the electrode $F_e$ of another set of electrodes $F_1$ to $F_4$ adjacent thereto in the lateral direction are interconnected. The cutting lines $X_1$, $X_2$, ... each pass through a position where the electrodes $C_1$ to $C_4$ and $C_e$ of one electrode set consisting thereof and the electrodes $C_1'$ to $C_4'$ and $C_e'$ of another electrode set consisting thereof and adjacent to the above electrode set in the vertical direction are interconnected and a position where the electrodes $D_1$ to $D_4$ and $D_e$ of one electrode set consisting thereof and the electrodes $D_1'$ to $D_4'$ and $D_e'$ of another electrode set consisting thereof and adjacent the abovesaid electrode set in the vertical direction are interconnected.

In this case, by cutting the substrate assembly along the cutting lines $Y_1$, $Y_2$, ... into individual devices, outer side walls are defined along the vertical cutting lines in connection with only those $E_1$ and $E_4$ of the electrodes $E_1$ to $E_4$ and $F_1$ to $F_4$ which are disposed at the opposite ends of each device, but no such side walls are formed with regard to the other electrodes $E_2$ to $E_4$ and $F_1$ to $F_3$. By cutting along the cutting lines $X_1$, $X_2$,..., too, no such side walls are formed along the lateral cutting lines with respect to the electrodes $E_1$ to $E_4$ and $F_1$ to $F_4$. This eliminates the possibility of shorting of the electrodes $E_i$ and $F_i$ by the materials thereof, even if the abovesaid cutting is effected by a laser beam. Further, by cutting along the cutting lines $X_1$, $X_2$, ..., the non-single-crystal semiconductor laminate member 11 is cut, but either of the contact portions $K_{e1}$ and $K_{i(i+1)}$ is not cut. On account of this, even if the abovesaid cutting is effected by a laser beam, there is no possibility that the material of the contact portion $K_{i(i+1)}$ enters into that region of the non-single-crystal semiconductor laminate member defined between the electrodes $E_i$ and $E_{i+1}$ on the side of the latter, resulting in shorting of the electrodes $E_i$ and $F_i$ through the abovesaid material and the contact portion $K_{i(i+1)}$.

While the foregoing description has been given of only one embodiment of each of the photoelectric conversion device and its manufacturing method according to the present invention, it is also possible to dispense with the isolation grooves 12, 12', 5 and 5' and the electrodes $C_1$ to $C_e$, $C_1'$ to $C_4'$ and $C_e'$, as shown in Fig. 9 which corresponds to Fig. 1.

Although the foregoing description has been given of the case where the contact groove $O_{i(i+1)}$ is circular and single, it is also possible to provide the contact groove $O_{i(i+1)}$ in a square, rectangular or elliptic form, and two or more such grooves may also be provided. Also it is possible that the isolation groove $H_{i(i+1)}$ is formed to extend into the non-single-crystal semiconductor laminate member 11 and, in some case, to the electrode $E_i$. Moreover, the contact groove $O_{i(i+1)}$ may also be formed to extend into the electrode $E_{i+1}$ and, in some cases, to the substrate 1.

It will be apparent that modifications and variations of the described embodiments may be effected without departing from the scope of the present invention as defined by the appended claims.

**Claims**

1. A photoelectric conversion device comprising a plurality of series-connected semiconductor transducers $U_1$, $U_2$, ... constituted by a non-single-crystal semiconductor lamina having side walls which extend in the direction of the serial arrangement of the semiconductor transducers $U_1$, $U_2$, ... and a plurality of spaced-apart first electrodes $E_1$, $E_2$, ... on one surface thereof in generally opposing relationship with a plurality of spaced-apart second electrodes $F_1$, $F_2$, ... on the opposite surface of the lamina, each of said electrodes having a major portion in opposing relation with a major portion of a respective one of the electrodes on the other side of the lamina and a minor portion in opposing relation with a minor portion of the next adjacent one of the electrodes on the other side of the lamina and connections $K_{12}$, $K_{23}$, ... being provided between the opposed minor portions of the electrodes on opposite sides of the lamina, characterized in that the connections $K_{12}$, $K_{23}$, ... are provided through apertures $O_{12}$, $O_{23}$, ... in the lamina which do not extend to said side walls of the lamina.

2. A photoelectric conversion device which comprises a plurality of series-connected semiconductor transducers $U_1$, $U_2$, ..., comprising:

a substrate having an insulating surface;

a plurality of first electrodes $E_1$, $E_2$, ... formed in side-by-side sequential relationship on the substrate;

a non-single-crystal semiconductor laminate member formed on the substrate to cover the first electrodes $E_1$, $E_2$, ..., said semiconductor laminate member having side walls which extend in the direction of the serial arrangement of the semiconductor transducers $U_1$, $U_2$, ...; and

a plurality of second electrodes $F_1$, $F_2$, ... formed on the non-single-crystal semiconductor laminate member in opposing relation to the first electrodes $E_1$, $E_2$, ..., respectively;

and wherein:

the semiconductor transducer $U_i$ (where i=1, 2, ...) is constituted by the first electrode $E_i$, the second electrode $F_i$ and a region $Q_i$ of the non-single-crystal semiconductor laminate member which is sandwiched between the first and second electrodes $E_i$ and $F_i$;

the second electrode $F_i$ is connected to the first electrode $E_{i+1}$ through a contact portion $K_{i(i+1)}$;

the plurality of first electrodes $E_1$, $E_2$, ... are isolated from adjacent first electrodes by respective ones of a plurality of first isolation grooves $G_{12}$, $G_{23}$, ... sequentially arranged along the direction of arrangement of the first electrodes;

the non-single-crystal semiconductor laminate member extends into the plurality of first isolation grooves $G_{12}$, $G_{23}$, ...;

the plurality of second electrodes $F_1$, $F_2$, ... are isolated from adjacent second electrodes by respective ones of a plurality of second isolation grooves $H_{12}$, $H_{23}$, ... sequentially arranged along

the direction of arrangement of the second electrodes;

the second isolation groove $H_{i(i+1)}$ extends in opposing relation to a region of the first electrode $E_{i+1}$ on one side of the isolation groove $G_{i(i+1)}$ and thereby the second electrode $F_i$ is opposite to said region of the first electrode $E_{i+1}$; and

in the region of the non-single-crystal semiconductor laminate member across which the second electrode $F_i$ is opposite to the first electrode $E_{i+1}$, there is provided a contact opening $O_{i(i+1)}$ which extends through the semiconductor laminate member between the second electrode $F_i$ and the first electrode $E_{i+1}$, the second electrode $F_i$ extending through the contact opening $O_{i(i+1)}$ to contact the first electrode $E_{i+1}$ and define the contact portion $K_{i(i+1)}$;

characterized in that the contact opening $O_{i(i+1)}$ does not extend to said side walls of the non-single-crystal semiconductor laminate member, so that the contact portion $K_{i(i+1)}$ likewise does not extend to the said side walls of the non-single-crystal semiconductor laminate member either.

3. A photoelectric conversion device according to claim 2, wherein the side wall of the first electrode $E_i$ and/or of the second electrode $F_i$ of the semiconductor transducer $U_i$ which extends in the direction of the serial arrangement of the semiconductor transducers $U_1$, $U_2$, ..., is disposed within the corresponding side wall of the substrate with a spacing therefrom.

4. A photoelectric conversion device according to claim 2 or 3, wherein the substrate is transparent and the first electrodes $E_1$, $E_2$, ... each comprise a transparent conductive layer.

5. A photoelectric conversion device according to claim 4, wherein the second electrodes $F_1$, $F_2$, ... each comprise a transparent conductive layer formed on the non-single-crystal semiconductor laminate member and a reflective conductive layer formed on the transparent conductive layer.

6. A photoelectric conversion device according to claim 2 or 3, wherein the second electrodes $F_1$, $F_2$, ... each comprise a transparent conductive layer.

7. A photoelectric conversion device according to claim 6, wherein the first electrodes $E_1$, $E_2$, ... each comprise a reflective conductive layer formed on the substrate and a transparent conductive layer formed on the reflective conductive layer.

8. A method of manufacturing a photoelectric conversion device comprising a plurality of series connected semiconductor transducers $U_1$, $U_2$, ... each comprising a non-single-crystal semiconductor lamina member $Q_i$ (where i=1, 2, ...) sandwiched between a respective first electrode $E_i$ and a respective second electrode $F_i$, the method comprising forming a plurality of spaced-apart first electrodes $E_i$ on the surface of an insulating substrate, forming a layer of non-single-crystal semiconductor material on the substrate so as to overlie said plurality of first electrodes, said semiconductor material layer having side walls which extend in the direction of the serial arrangement of the semiconductor transducers $U_1$, $U_2$, ..., forming a plurality of contact openings $O_{i(i+1)}$ through said semiconductor material layer so as to provide access to said plurality of first electrodes adjacent one edge thereof, and forming a plurality of spaced-apart second electrodes $F_i$ on the surface of said semiconductor material layer so that each second electrode $F_i$ has a portion overlapping said edge of the next adjacent first electrode $E_{i+1}$ and has a contact portion $K_{i(i+1)}$ which extends into the opening $O_{i(i+1)}$ and contacts the first electrode $E_{i+1}$, characterized in that the openings $O_{i(i+1)}$ do not extend to said side walls of the semiconductor material layer.

9. A method of manufacturing a photoelectric conversion device which comprises a plurality of series-connected semiconductor transducers $U_1$, $U_2$, ..., said method comprising the steps of:

forming a first electrically conductive layer on a substrate having an insulating surface;

scribing the first electrically conductive layer by means of a laser beam so as to form therein a plurality of sequentially arranged first isolation grooves $G_{12}$, $G_{23}$, ... by virtue of which a plurality of sequentially arranged first electrodes $E_1$, $E_2$, ... are defined on the substrate,

forming a non-single-crystal semiconductor laminate member on the substrate so as to cover the plurality of first electrodes $E_1$, $E_2$, ... and to fill the plurality of first isolation grooves $G_{12}$, $G_{23}$, ..., said semiconductor laminate member having side walls which extend in the direction of the serial arrangement of the semiconductor transducers $U_1$, $U_2$ ...;

forming contact openings $O_{12}$, $O_{23}$, ... in the non-single-crystal semiconductor laminate member by use of a laser beam so as to expose respective regions of the first electrodes $E_2$, $E_3$, ... on one side of the first isolation grooves $G_{12}$, $G_{23}$, ..., respectively;

forming a second electrically conductive layer which covers the non-single-crystal semiconductor laminate member and extends into the contact openings $O_{12}$, $O_{23}$, ... to form contact portions $K_{12}$, $K_{23}$, ... in contact with the first electrodes $E_2$, $E_3$, ... respectively; and

scribing the second electrically conductive layer by means of a laser beam so as to form therein second isolation grooves $H_{12}$, $H_{23}$, ... which define on the non-single-crystal semiconductor laminate member second electrodes $F_1$, $F_2$, ... connected to respective ones of the first electrodes $E_2$, $E_3$, ... through respective ones of the contact portions $K_{12}$, $K_{23}$, ...;

characterized in that the contact openings $O_{i(i+1)}$ (where i=1, 2, ...) are formed so as not to extend to said side walls of the non-single-crystal semiconductor laminate member.

10. A method according to claim 9, wherein, in the step of scribing the first electrically conductive layer, there is cut in the first electrically conductive layer at least one further isolation groove which extends in the direction of the serial arrangement of the semiconductor transducers $U_1$, $U_2$, ....

11. A method according to claim 9 or 10 wherein in the step of scribing the second electrically conductive layer, there is cut in the second electrically conductive layer at least one further isolation groove which extends in the direction of the serial arrangement of the semiconductor transducers $U_1$, $U_2$,....

12. A method according to claim 9 or 10 or 11 wherein the laser beam scribing is performed with a laser having a wavelength of 600 nm or less.

13. A method according to any of claims 10 to 12, wherein the substrate is a transparent substrate and the first electrically conductive layer is formed as a transparent conductive layer.

14. The method according to claim 13, wherein the second electrically conductive layer comprises a transparent conductive layer formed on the non-single-crystal semiconductor laminate member and a reflective conductive layer formed on the transparent conductive layer.

15. A method according to any of claims 10 to 12, wherein the second electrically conductive layer is formed as a transparent conductive layer.

16. A method according to claim 15, wherein the first electrically conductive layer comprises a reflective conductive layer formed on the substrate and a transparent conductive layer formed on the reflective conductive layer.

**Patentansprüche**

1. Photoelektrische Unsetzeranordnung mit einer Vielzahl von in Serie geschalteten Halbleiterwandlern $U_1$, $U_2$, ..., die gebildet sind von einem nicht-monokristallinen Halbleiterplättchen mit in der Richtung der Serienanordnung der Halbleiterwandler $U_1$, $U_2$, ... verlaufenden Seitenwänden und einer Vielzahl von in Abstand voneinander angeordneten ersten Elektroden $E_1$, $E_2$, ... auf einer Oberfläche, die einer Vielzahl von in Abstand voneinander angeordneten zweiten Elektroden $F_1$, $F_2$, ... auf der anderen Oberfläche des Plättchens generell gegenüber angeordnet sind, wobei jede der Elektroden einen Hauptabschnitt aufweist, der einem Hauptabschnitt einer entsprechenden Elektrode auf der anderen Seite des Plättchens gegenüberliegt, und einen Nebenabschnitt, der einem Nebenabschnitt der jeweils benachbarten Elektrode auf der anderen Seite des Plättchens gegenüberliegt, und wobei zwischen den gegenüberliegenden Nebenabschnitten der Elektroden auf gegenüberliegenden Seiten des Plättchens Verbindungen $K_{12}$, $K_{23}$, ... vorgesehen sind, dadurch gekennzeichnet, daß die Verbindungen $K_{12}$, $K_{23}$, ... durch Öffnungen $O_{12}$, $O_{23}$, ... in dem Plättchen verlaufen, die sich nicht bis zu den Seitenwänden des Plättchens erstrecken.

2. Photoelektrische Umsetzeranordnung mit einer Vielzahl von in Serie geschalteten Halbleiterwandlern $U_1$, $U_2$, ..., umfassend

ein Substrat mit einer isolierenden Oberfläche;

eine Vielzahl von seitlich aufeinanderfolgend auf dem Substrat ausgebildeten ersten Elektroden $E_1$, $E_2$, ...;

ein auf dem Substrat ausgebildetes, die ersten Elektroden $E_1$, $E_2$, ... bedeckendes nicht-monokristallines Halbleiter-Schichtelement mit Seitenwänden, die in der Richtung der Serienanordnung der Halbleiterwandler $U_1$, $U_2$, ... verlaufen; und

eine Vielzahl von auf dem nicht-monokristallinen Halbleiter-Schichtelement den ersten Elektroden $E_1$, $E_2$,... jeweils gegenüber angeordneten zweiten Elektroden $F_1$, $F_2$,...;

wobei

der Halbleiterwandler $U_i$ (mit i=1, 2,...) von der ersten Elektrode $E_i$, der zweiten Elektrode $F_i$ und einem zwischen der ersten und der zweiten Elektrode $E_i$, $F_i$ sandwich-artig liegenden Bereich $Q_i$ des nicht-monokristallinen Halbleiter-Schichtelements gebildet ist;

die zweite Elektrode $F_i$ mit der ersten Elektrode $E_{i+1}$ über einen Kontaktabschnitt $K_{i(i+1)}$ verbunden ist;

die Vielzahl von ersten Elektroden $E_1$, $E_2$,' von benachbarten ersten Elektroden jeweils durch eine Vielzahl von ersten Isolationsnuten $G_{12}$, $G_{23}$,' isoliert ist, die in der Richtung der Anordnung der ersten Elektroden aufeinanderfolgend angeordnet sind;

das nicht-monokristalline Halbleiter-Schichtelement sich in die Vielzahl von ersten Isolationsnuten $G_{12}$, $G_{23}$,' erstreckt;

die Vielzahl von zweiten Elektroden $F_1$, $F_2$,' von benachbarten zweiten Elektroden jeweils durch eine Vielzahl von Isolationsnuten $H_{12}$, $H_{23}$,' isoliert ist, die in der Richtung der Anordnung der zweiten Elektroden aufeinanderfolgend angeordnet sind;

die zweite Isolationsnut $H_{i(i+1)}$ gegenüber einem Bereich der ersten Elektrode $E_{i+1}$ auf einer Seite der Isolationsnut $G_{i(i+1)}$ verläuft und dadurch die zweite Elektrode $F_1$ dem besagten Bereich der ersten Elektrode $E_{i+1}$ gegenüberliegt; und

in dem Bereich des nicht-monokristallinen Halbleiter-Schichtelements, an dem die zweite Elektrode $F_i$ der ersten Elektrode $E_{i+1}$ gegenüberliegt, eine Kontaktöffnung $O_{i(i+1)}$ vorgesehen ist, die das Halbleiter-Schichtelement zwischen der zweiten Elektrode $F_i$ und der ersten Elektrode $E_{i+1}$ durchsetzt, wobei die zweite Elektrode $F_i$ durch die Kontaktöffnung $O_{i(i+1)}$ so verläuft, daß sie die erste Elektrode $E_{i+1}$ kontaktiert und den Kontaktabschnitt $K_{i(i+1)}$ definiert;

dadurch gekennzeichnet, daß die Kontaktöffnung $O_{i(i+1)}$ nicht bis zu den Seitenwänden des nicht-monokristallinen Halbleiter-Schichtelements verläuft, so daß sich auch der Kontaktabschnitt $K_{i(i+1)}$ nicht bis zu den Seitenwänden des nichtmonokristallinen Halbleiter-Schichtelements erstreckt.

3. Photoelektrische Umsetzeranordnung nach Anspruch 2, wobei die in der Richtung der Serienanordnung der Halbleiterwandler $U_1$, $U_2$, ... verlaufende Seitenwand der ersten Elektrode $E_i$ und/oder der zweiten Elektrode $F_i$ des Halbleiterwandlers $U_i$ innerhalb der entsprechenden Seitenwand des Substrats in Abstand von diesem angeordnet ist.

4. Photoelektrische Umsetzeranordnung nach

Anspruch 2 oder 3, wobei das Substrat transparent ist und die ersten Elektroden $E_1$, $E_2$, ... jeweils eine transpartente leitfähige Schicht aufweisen.

5. Photoelektrische Umsetzeranordnung nach Anspruch 4, wobei die zweiten Elektroden $F_1$, $F_2$, ... jeweils eine auf dem nicht-monokristallinen Halbleiter-Schichtelement ausgebildete transparente leitfähige Schicht und eine auf dieser ausgebildete reflektierende leitfähige Schicht aufweisen.

6. Photoelektrische Umsetzeranordnung nach Anspruch 2 oder 3, wobei die zweiten Elektroden $F_1$, $F_2$, ... jeweils eine transparente leitfähige Schicht aufweisen.

7. Photoelektrische Umsetzeranordnung nach Anspruch 6, wobei die ersten Elektroden $E_1$, $E_2$, ... jeweils ein auf dem Substrat ausgebildete reflektierende leitfähige Schicht und eine auf dieser ausgebildete transparente leitfähige Schicht aufweisen.

8. Verfahren zur Herstellung einer photoelektrischen Umsetzeranordnung mit einer Vielzahl von in Serie geschalteten Halbleiterwandlern $U_1$, $U_2$, ..., die jeweils ein zwischen einer jeweiligen ersten Elektrode $E_i$ und einer jeweiligen zweiten Elektrode $F_i$ sandwich-artig angeordnetes nicht-monokristallines Halbleiterplättchen-Element $Q_i$ (mit i=1, 2,...) aufweisen, umfassend das Ausbilden einer Vielzahl von in Abstand voneinander angeordneten ersten Elektroden $E_i$ auf der Oberfläche eines isolierenden Substrats, das Ausbilden einer Schicht aus nicht-monokristallinem Halbleitermaterial auf dem Substrat in der Weise, daß sie über der Vielzahl von ersten Elektroden liegt, wobei die Halbleitermaterial-Schicht Seitenwände aufweist, die in der Richtung der Serienanordnung der Halbleiterwandler $U_1$, $U_2$, ... verlaufen, das Ausbilden einer Vielzahl von Kontaktöffnungen $O_{i(i+1)}$ durch die Halbleitermaterial-Schicht hindurch, so daß zu der Vielzahl von ersten Elektroden nahe deren einer Kante Zugang geschaffen wird, und das Ausbilden einer Vielzahl von in Abstand voneinander angeordneten zweiten Elektroden $F_i$ auf der Oberfläche der Halbleitermaterial-Schicht in der Weise, daß jede zweite Elektrode $F_i$ einen die besagte Kante der jeweils benachbarten ersten nächsten Elektrode $E_{i+1}$ überlappt und einen Kontaktabschnitt $K_{i(i+1)}$ aufweist, der sich in die Öffnung $O_{i(i+1)}$ erstreckt und die erste Elektrode $E_{i+1}$ kontaktiert, dadurch gekennzeichnet, daß sich die Öffnungen $O_{i(i+1)}$ nicht bis zu den Seitenwänden der Halbleitermaterial-Schicht erstrecken.

9. Verfahren zur Herstellung einer photoelektrischen Umsetzeranordnung mit einer Vielzahl von in Serie geschalteten Halbleiterwandlern $U_1$, $U_2$, ..., umfassend die folgenden Schritte:

Ausbilden einer ersten elektrisch leitfähigen Schicht auf einem Substrat mit einer isolierenden Oberfläche;

Ritzen der ersten elektrisch leitfähigen Schicht mittels eines Laserstrahls, um darin eine Vielzahl von aufeinanderfolgend angeordneten ersten Isolationsnuten $G_{12}$, $G_{23}$, ... auszubilden, durch die auf dem Substrat eine Vielzahl von aufeinanderfolgend angeordneten ersten Elektroden $E_1$, $E_2$, ... definiert werden,

Ausbilden eines nicht-monokristallinen Halbleiter-Schichtelements auf dem Substrat in der Weise, daß es die Vielzahl von ersten Elektroden $E_1$, $E_2$, ... bedeckt und die Vielzahl von ersten Isolationsnuten $G_{12}$, $G_{23}$, ... ausfüllt, wobei das Halbleiter-Schichtelement Seitenwände aufweist, die in der Richtung der Serienanordnung der Halbleiterwandler $U_1$, $U_2$,... verlaufen;

Ausbilden von Kontaktöffnungen $O_{12}$, $O_{23}$, ... in dem nicht-monokristallinen Halbleiter-Schichtelement unter Verwendung eines Laserstrahls, um jeweils Bereiche der ersten Elektroden $E_2$, $E_3$, ... auf einer Seite der jeweiligen ersten Isolationsnuten $G_{12}$, $G_{23}$, ... freizulegen;

Ausbilden einer zweiten elektrisch leitfähigen Schicht, die das nicht-monokristalline Halbleiter-Schichtelement bedeckt und sich in die Kontaktöffnungen $O_{12}$, $O_{23}$,... erstreckt, um Kontaktabschnitte $K_{12}$, $K_{23}$, ... in Kontakt mit dem jeweiligen ersten Elektroden $E_2$, $E_3$, ... zu bilden; und

Ritzen der zweiten elektrisch leitfähigen Schicht mittels eines Laserstrahls, um darin zweite Isolationsnuten $H_{12}$, $H_{23}$, ... auszubilden, die auf dem nicht-monokristallinen Halbleiter-Schichtelement zweite Elektroden $F_1$, $F_2$, ... definieren, die mit den jeweiligen ersten Elektroden $E_2$, $E_3$, ... über jeweilige Kontaktöffnungen $K_{12}$, $K_{23}$, ... verbunden sind;

dadurch gekennzeichnet, daß die Kontaktöffnungen $O_{i(i+1)}$ (mit i=1, 2, ...) so ausgebildet werden, daß sie sich nicht bis zu den Seitenwänden des nicht-monokristallinen Halbleiter-Schichtelements erstrecken.

10. Verfahren nach Anspruch 9, wobei beim Ritzen der ersten elektrisch leitfähigen Schicht in diese mindestens eine weitere Isolationsnut geschnitten wird, die in der Richtung der Serienanordnung der Halbleiterwandler $U_1$, $U_2$, ... verläuft.

11. Verfahren nach Anspruch 9 oder 10, wobei beim Ritzen der zweiten elektrisch leitfähigen Schicht in diese mindestens eine weitere Isolationsnut geschnitten wird, die in der Richtung der Serienanordnung der Halbleiterwandler $U_1$, $U_2$, ... verläuft.

12. Verfahren nach Anspruch 9, 10 oder 11, wobei die Laserstrahl-Ritzung mit einem Laser durchgeführt wird, der eine Wellenläge von 600 nm oder weniger aufweist.

13. Verfahren nach einem der Ansprüche 10 bis 12, wobei das Substrat ein transparentes Substrat ist und die erste elektrisch leitfähige Schicht als transparente leitfähige Schicht ausgebildet wird.

14. Verfahren nach Anspruch 13, wobei die zweite elektrisch leitfähige Schicht eine auf dem nicht-monokristalline Halbleiter-Schichtelement ausgebildete transparente leitfähige Schicht und eine auf dieser ausgebildete reflektierende leitfähige Schicht aufweist.

15. Verfahren nach einem der Ansprüche 10 bis 12, wobei die zweite elektrisch leitfähige Schicht als transparente leitfähige Schicht ausgebildet wird.

16. Verfahren nach Anspruch 15, wobei die erste elektrisch leitfähige Schicht eine auf dem Substrate ausgebildete reflektierende leitfähige Schicht und eine auf dieser ausgebildete transparente leitfähige Schicht aufweist.

**Revendications**

1. Dispositif de conversion photoélectrique comportant une pluralité de transducteurs à semiconducteurs $U_1$, $U_2$, ..., branchés en série et constitués par un stratifié semiconducteur non monocristallin, possédant des parois latérales qui s'étendent dans la direction du montage en série des transducteurs à semiconducteurs $U_1$, $U_2$, ... et une pluralité de premières électrodes espacées $E_1$, $E_2$, ... situées sur une surface du stratifié et disposées sensiblement en vis-à-vis d'une pluralité de secondes électrodes espacées $F_1$, $F_2$, ... situées sur la surface opposée du stratifié, chacune desdites électrodes possédant une partie principale située en vis-à-vis d'une partie principale de l'une respective des électrodes situées sur l'autre face du stratifié, et une petite partie située en vis-à-vis d'une petite de l'électrode immédiatement voisine faisant partie des électrodes de l'autre face du stratifié, tandis que des connexions $K_{12}$, $K_{23}$, ... sont prévues entre les petites parties, situées en vis-à-vis, des électrodes sur les faces opposées du stratifié, caractérisé en ce que les connexions $K_{12}$, $K_{23}$, ... sont prévues dans des ouvertures $O_{12}$, $O_{23}$, ..., qui sont ménagées dans le stratifié et ne s'étendent pas jusqu'auxdites parois latérales du stratifié.

2. Dispositif de conversion photoélectrique comprenant une pluralité de transducteurs à semiconducteurs $U_1$, $U_2$, ..., branchés en série, comportant:

—un substrat possédant une surface isolante;

—une pluralité de premières électrodes $E_1$, $E_2$, ... formées côte-à-côte, à la suite les unes des autres, sur le substrat:

—un élément stratifié semiconducteur non monocristallin formé sur le substrat de manière à recouvrir les premières électrodes $E_1$, $E_2$, ..., ledit élément stratifié semiconducteur comportant des parois latérales qui s'étendent dans la direction de montage en série des transducteurs à semiconducteurs $U_1$, $U_2$, ...; et

—une pluralité de secondes électrodes ($F_1$, $F_2$, ... formées sur l'élément stratifié semiconducteur non monocristallin, en étant situées respectivement en vis-à-vis des premières électrodes $E_1$, $E_2$, ...;

—et dans lequel le transducteur à semiconducteurs $U_i$ (avec i=1, 2 ...) est constitué par la première électrode $E_i$, par la seconde électrode $F_i$ et par une région $Q_i$ de l'élément stratifié semiconducteur non monocristallin, qui est enserré entre les première et seconde électrodes $E_i$ et $F_i$;

—la seconde électrode $F_i$ est raccordée à la première électrode $E_{i+1}$ par l'intermédiaire d'un élément de contact $K_{i(i+1)}$;

—les différentes premières électrodes $E_1$, $E_2$, ... sont isolées de premières électrodes voisines par des gorges respectives d'une pluralité de premières gorges isolantes $G_{12}$, $G_{23}$, ... disposées les unes à la suite des autres dans la direction de montage des premières électrodes;

—l'élément stratifié semiconducteur non monocristallin s'étend à l'intérieur des différentes premières gorges isolantes $G_{12}$, $G_{23}$, ...;

—les différentes secondes électrodes, $F_1$, $F_2$, ... sont isolées vis-à-vis de secondes électrodes voisines par des gorges respectives faisant partie d'une pluralité de secondes gorges isolantes $H_{12}$, $H_{23}$, ... disposées les unes à la suite des autres dans la direction de montage des secondes électrodes;

—la seconde gorge isolante $H_{i(i+1)}$ s'étend en étant située en vis-à-vis d'une région de la première électrode $E_{i+1}$, d'un côté de la gorge isolante ($G_{i(i+1)}$ et de ce fait la seconde électrode $F_i$ est située en vis-à-vis de ladite région de la première électrode $E_{i+1}$; et

—dans la région de l'élément stratifié semiconducteur non monocristallin, au niveau de laquelle la seconde électrode $F_i$ est située en vis-à-vis de la première électrode $E_{i+1}$, il est prévu une ouverture de contact $O_{i(i+1)}$ qui traverse l'élément stratifié semiconducteur entre la seconde électrode $F_i$ et la première électrode $E_{i+1}$, et la seconde électrode $F_i$ s'étend à travers l'ouverture de contact $O_{i(i+1)}$ de manière à être en contact avec la première électrode $E_{i+1}$ et à définir l'élément de contact $K_{i(i+1)}$;

caractérisé en ce que l'ouverture de contact $O_{i(i+1)}$ ne s'étend par jusqu'auxdites parois latérales de l'élément stratifié semiconducteur non monocristallin, de sorte que, de façon analogue, l'élément de contact $K_{i(i+1)}$ ne s'étend pas jusqu'auxdites parois latérales de l'élément stratifié semiconducteur non monocristallin.

3. Dispositif de conversion photoélectrique selon la revendication 2, dans lequel la paroi latérale de la première électrode $E_i$ et/ou de la seconde électrode $F_i$ du transducteur à semiconducteurs $U_i$, qui s'étend dans la direction du montage en série des transducteurs à semiconducteurs $U_1$, $U_2$, ..., est disposée à l'intérieur de la paroi latérale correspondante du substrat, tout en en étant espacée.

4. Dispositif de conversion photoélectrique selon la revendication 2 ou 3, dans lequel le substrat est transparent et les premières électrodes $E_1$, $E_2$, ... comprennent chacune une couche conductrice transparente.

5. Dispositif de conversion photoélectrique selon la revendication 4, dans lequel les secondes électrodes $F_1$, $F_2$, ... comprennent chacune une couche conductrice transparente formée sur l'élément stratifié semiconducteur non monocristallin et une couche conductrice réfléchissante formée sur la couche conductrice transparente.

6. Dispositif de conversion photoélectrique selon la revendication 2 ou 3, dans lequel les secondes électrodes $F_1$, $F_2$, ... comprennent chacune une couche conductrice transparente.

7. Dispositif de conversion photoélectrique selon la revendication 6, dans lequel les premières électrodes $E_1$, $E_2$, ... comprennent chacune

une couche conductrice réfléchissante formée sur le substrat et une couche conductrice transparente formée sur la couche conductrice réfléchissante.

8. Procédé de fabrication d'un dispositif de conversion photoélectrique comportant une pluralité de transducteurs à semiconducteurs $U_1$, $U_2$, ... branchés en série et comprenant chacun un élément stratifié semiconducteur non monocristallin $Q_i$ (i=1, 2, ...) enserré entre une première électrode respective $E_i$ et une seconde électrode respective $F_i$, le procédé consistant à former une pluralité de premières électrodes espacées $E_i$ sur la surface d'un substrat isolant, à former une couche d'un matériau semiconducteur non monocristallin sur le substrat de manière qu'il recouvre ladite pluralité des premières électrodes, ladite couche de matériau semiconducteur comportant des parois latérales qui s'étendent dans la direction de montage en série des transducteurs à semiconducteurs $U_1$, $U_2$, ..., à former une pluralité d'ouvertures de contact $O_{i(i+1)}$ dans ladite couche de matériau semiconducteur de manière à permettre un accès à ladite pluralité des premières électrodes au voisinage d'un de leurs bords, et à former une pluralité de secondes électrodes espacées $F_i$ sur la surface de ladite couche de matériau semiconducteur de manière que chaque seconde électrode $F_i$ possède une partie recouvrant ledit bord de la première électrode directement voisine $E_{i+1}$ et possède un élément de contact $K_{i(i+1)}$ qui s'étend dans l'ouverture $O_{i(i+1)}$ et est en contact avec la première électrode $E_{i+1}$, caractérisé en ce que les ouvertures $O_{i(i+1)}$ ne s'étendent pas jusqu'auxdites parois latérales de la couche de matériau semiconducteur.

9. Procédé pour fabriquer un dispositif de conversion photoélectrique qui comporte une pluralité de transducteurs à semiconducteurs $U_1$, $U_2$, ... branchés en série, ledit procédé incluant les étapes consistant à:

—former une première couche électriquement conductrice sur un substrat possédant une surface isolante;

—graver la première couche électriquement conductrice à l'aide d'un faisceau laser de manière à former dans cette couche une pluralité de premières gorges isolantes $G_{12}$, $G_{23}$, ... disposées les unes à la suite des autres et à l'aide desquelles une pluralité de premières électrodes $E_1$, $E_2$, ... disposées les unes à la suite des autres sont définies sur le substrat,

—former un élément stratifié semiconducteur non monocristallin sur le substrat de manière à recouvrir la pluralité des premières électrodes $E_1$, $E_2$, ... et à remplir la pluralité des premières gorges isolantes $G_{12}$, $G_{23}$, ..., ledit élément stratifié semiconducteur comportant des parois latérales qui s'étendent dans la direction de montage en série des transducteurs à semiconducteurs $U_1$, $U_2$, ...,

—former des ouvertures de contact $O_{12}$, $O_{23}$, ... dans l'élément stratifié semiconducteur non monocristallin en utilisant un faisceau laser de manière à mettre à nu des régions respectives des premières électrodes $E_2$, $E_3$, ... respectivement sur une face des premières gorges isolantes $G_{12}$, $G_{23}$, ...,

—former une seconde couche électriquement conductrice qui recouvre l'élément stratifié semiconducteur non monocristallin et s'étend à l'intérieur des ouvertures de contact $O_{12}$, $O_{23}$, ... de manière à former des éléments de contact $K_{12}$, $K_{23}$, ... respectivement en contact avec les premières électrodes $E_2$, $E_3$, ...; et

—graver la seconde couche électriquement conductrice à l'aide d'un faisceau laser de manière à former dans cette couche des secondes gorges isolantes $H_{12}$, $H_{23}$, ... qui définissent, sur l'élément stratifié semiconducteur non monocristallin, des secondes électrodes $F_1$, $F_2$, ... raccordées à des électrodes respectives faisant partie des premières électrodes $E_2$, $E_3$, ... par l'intermédiaire d'éléments respectifs faisant partie des éléments de contact $K_{12}$, $K_{23}$, ...;

—caractérisé en ce que les ouvertures de contact $O_{i(i+1)}$ (i=1, 2, ...) sont formées de manière à ne pas s'étendre jusqu'auxdites parois latérales de l'élément stratifié semiconducteur non monocristallin.

10. Procédé selon la revendication 9, selon lequel, lors de l'étape de gravure de la première couche électriquement conductrice, on découpe dans cette dernière au moins une gorge isolante supplémentaire qui s'étend dans la direction du montage en série des transducteurs à semiconducteurs $U_1$, $U_2$, ....

11. Procédé selon la revendication 9 ou 10, selon lequel, lors de l'étape de gravure de la seconde couche électriquement conductrice, on découpe dans cette dernière au moins une gorge isolante supplémentaire qui s'étend dans la direction de montage en série des transducteurs à semiconducteurs $U_1$, $U_2$, ....

12. Procédé selon la revendication 9 ou 10 ou 11, selon lequel le faisceau laser utilisé pour la gravure est constitué par un laser possédant une longueur d'onde de 600 nm ou moins.

13. Procédé selon l'une quelconque des revendications 10 à 12, selon lequel le substrat est un substrat transparent et la première couche électriquement conductrice est réalisée sous la forme d'une couche conductrice transparente.

14. Procédé selon la revendication 13, selon lequel la seconde couche électriquement conductrice comprend une couche conductrice transparente formée sur l'élément stratifié semiconducteur non monocristallin et une couche conductrice réfléchissante formée sur la couche conductrice transparente.

15. Procédé selon l'une quelconque des revendications 10 à 12, selon lequel la seconde couche électriquement conductrice est réalisée sous la forme d'une couche conductrice transparente.

16. Procédé selon la revendication 15, selon lequel la première couche électriquement conductrice comporte une couche conductrice réfléchissante formée sur le substrat et une couche conductrice transparente formée sur la couche conductrice réfléchissante.

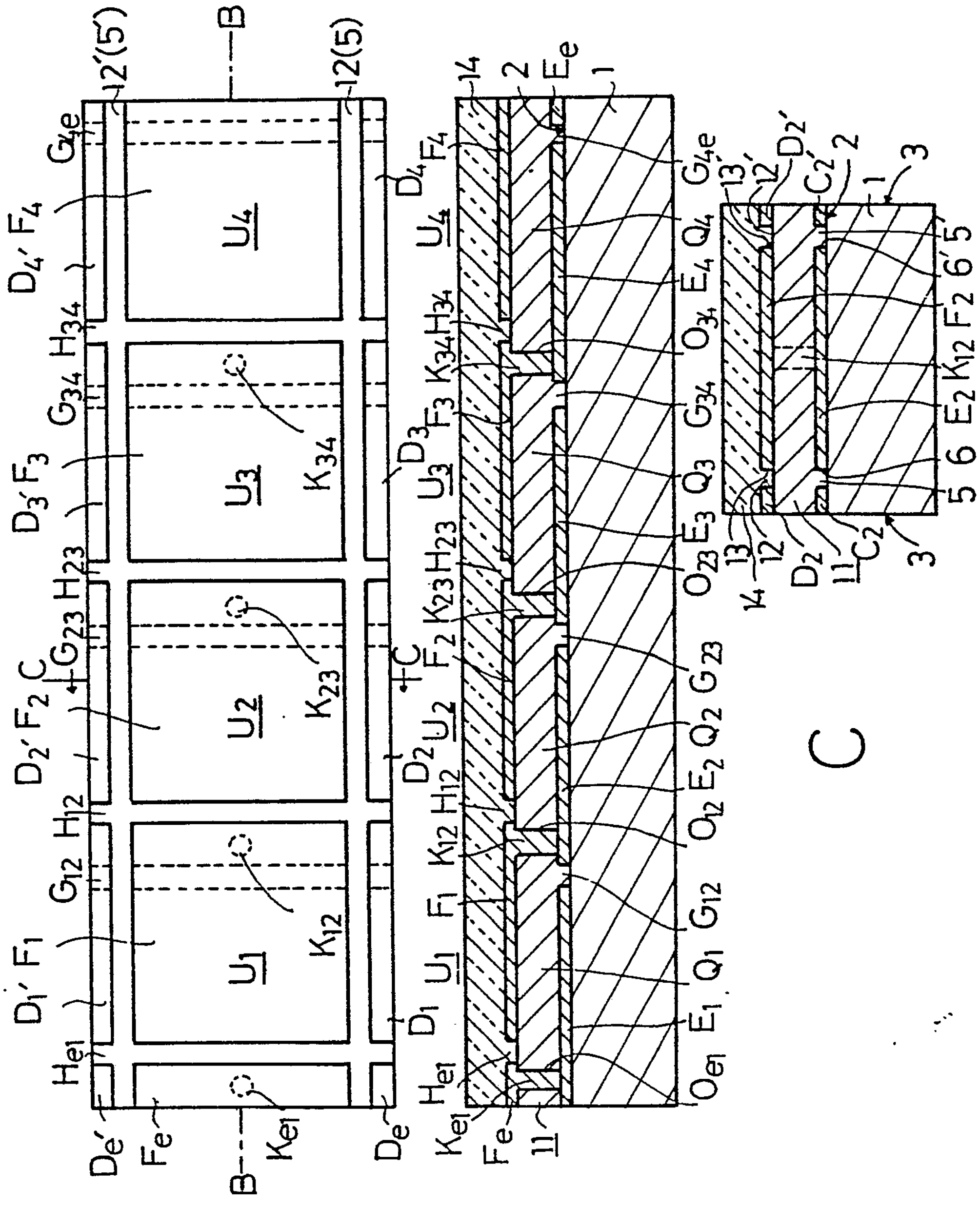


Fig. 1

Fig. 2

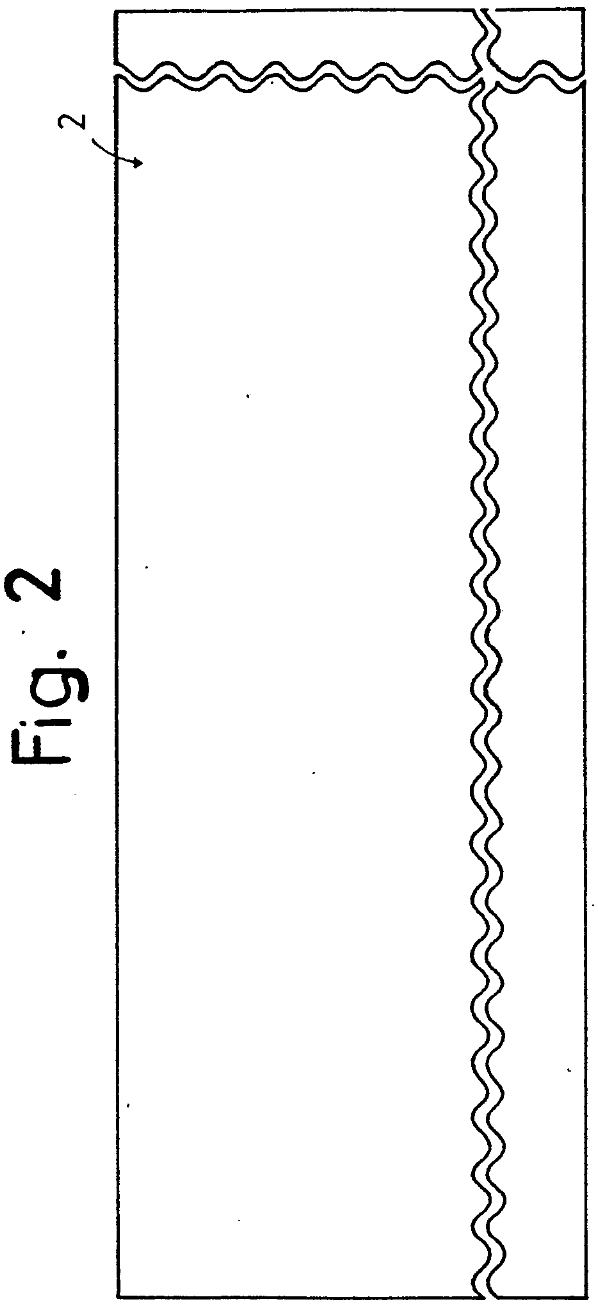


A

Fig. 3

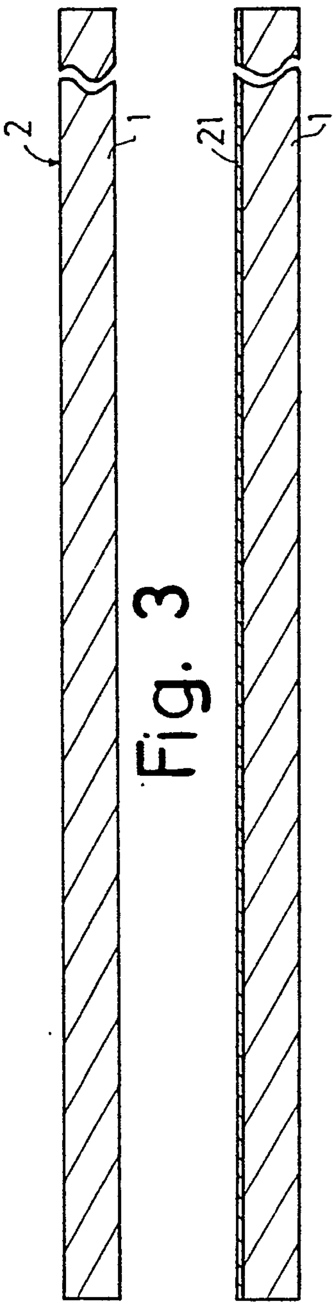


B

Fig. 4

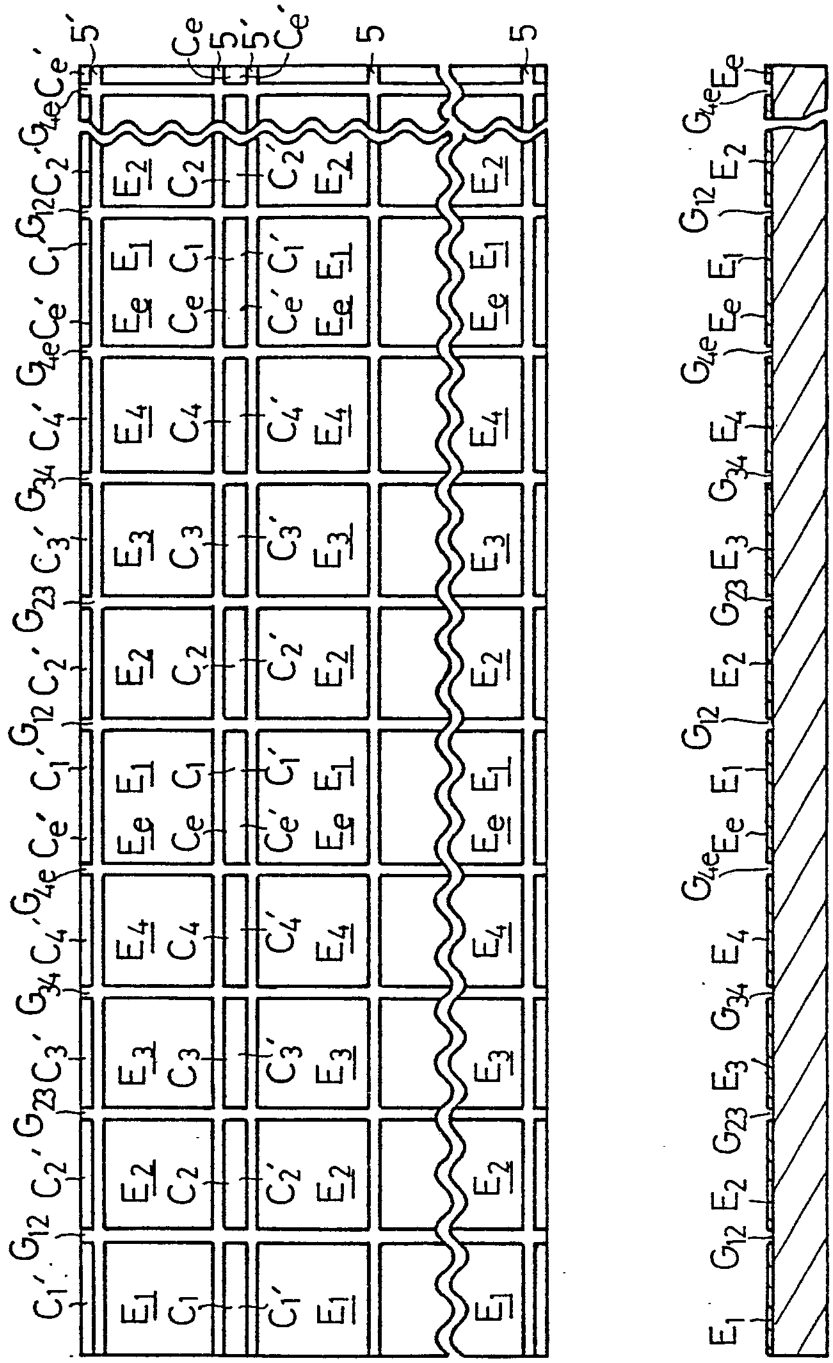


A

B

Fig. 5

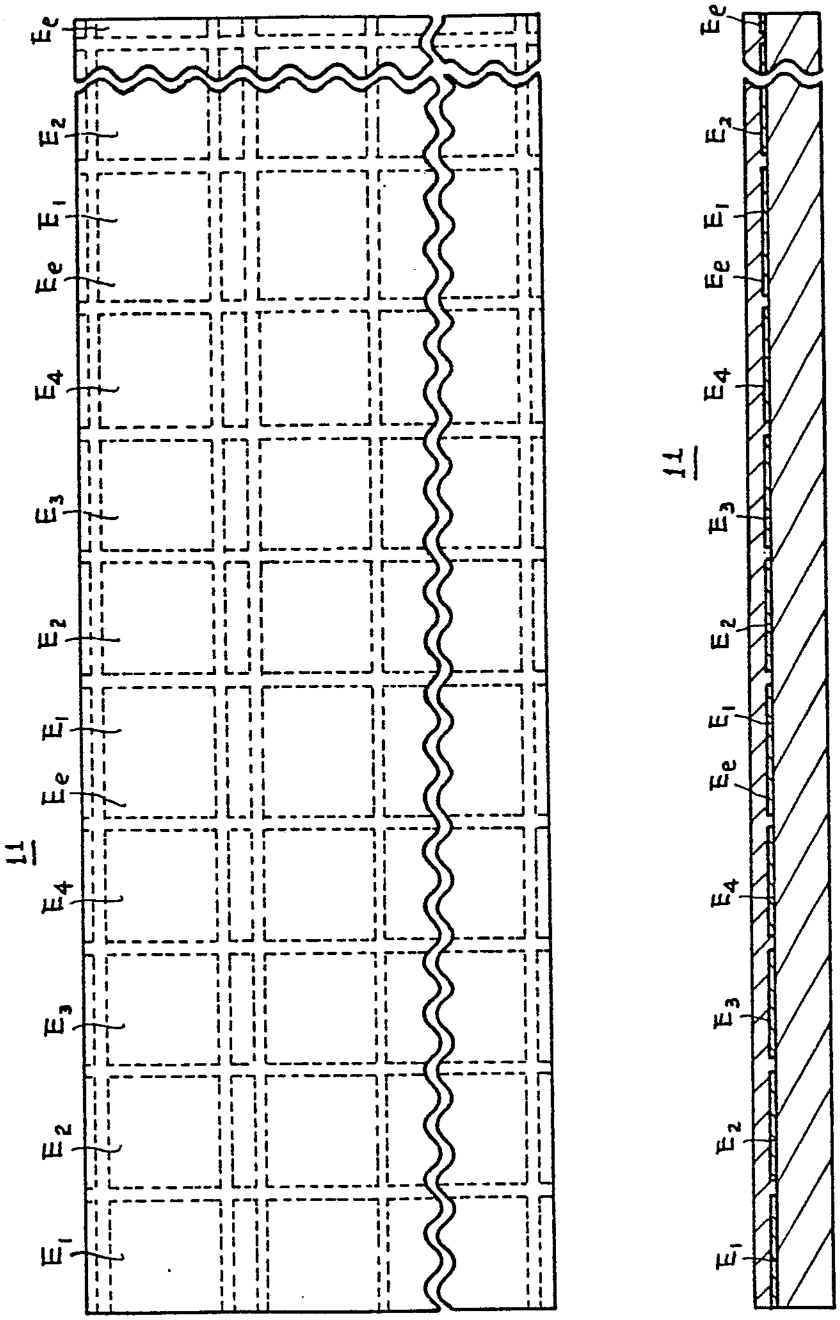


A

B

Fig. 6

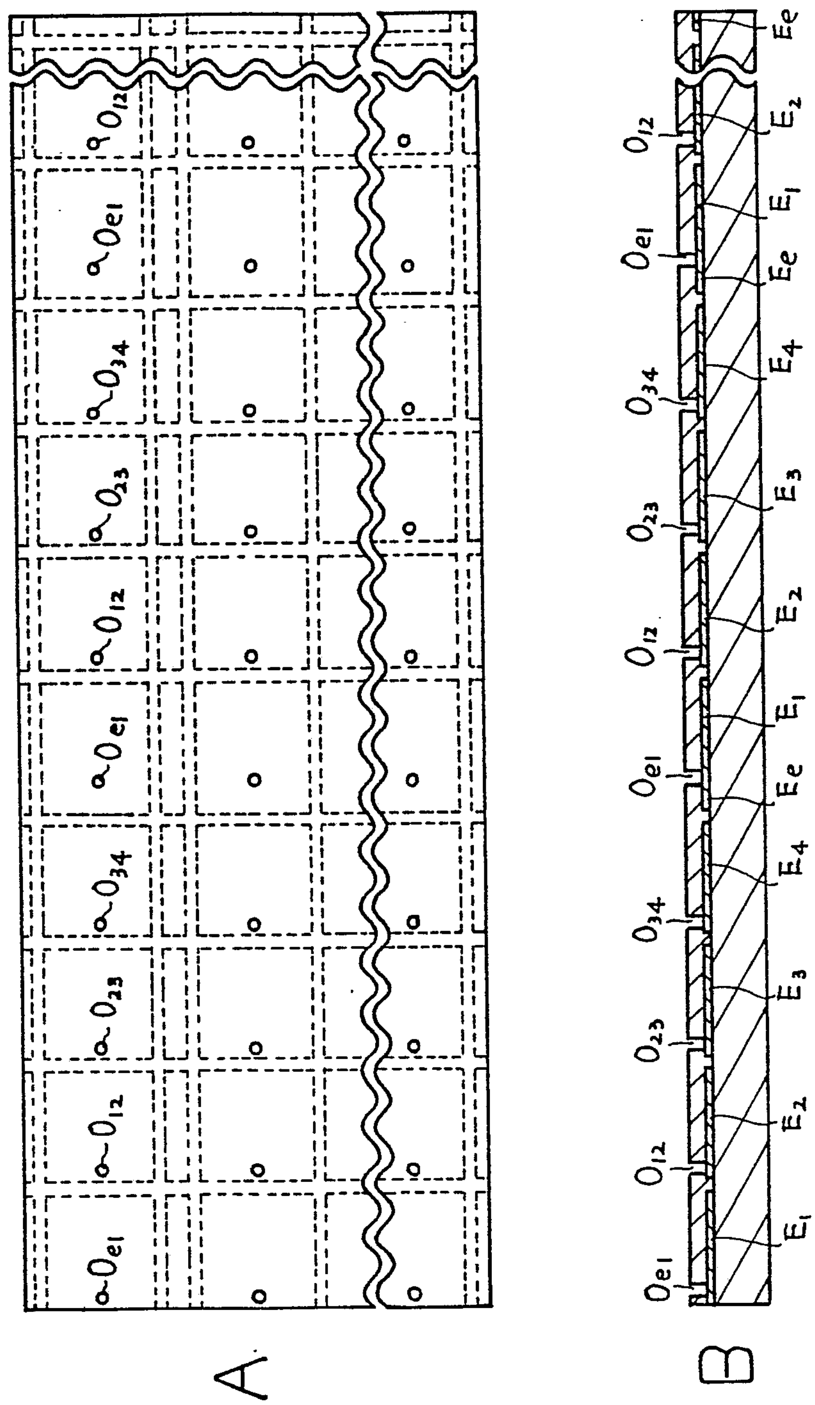

Fig. 7

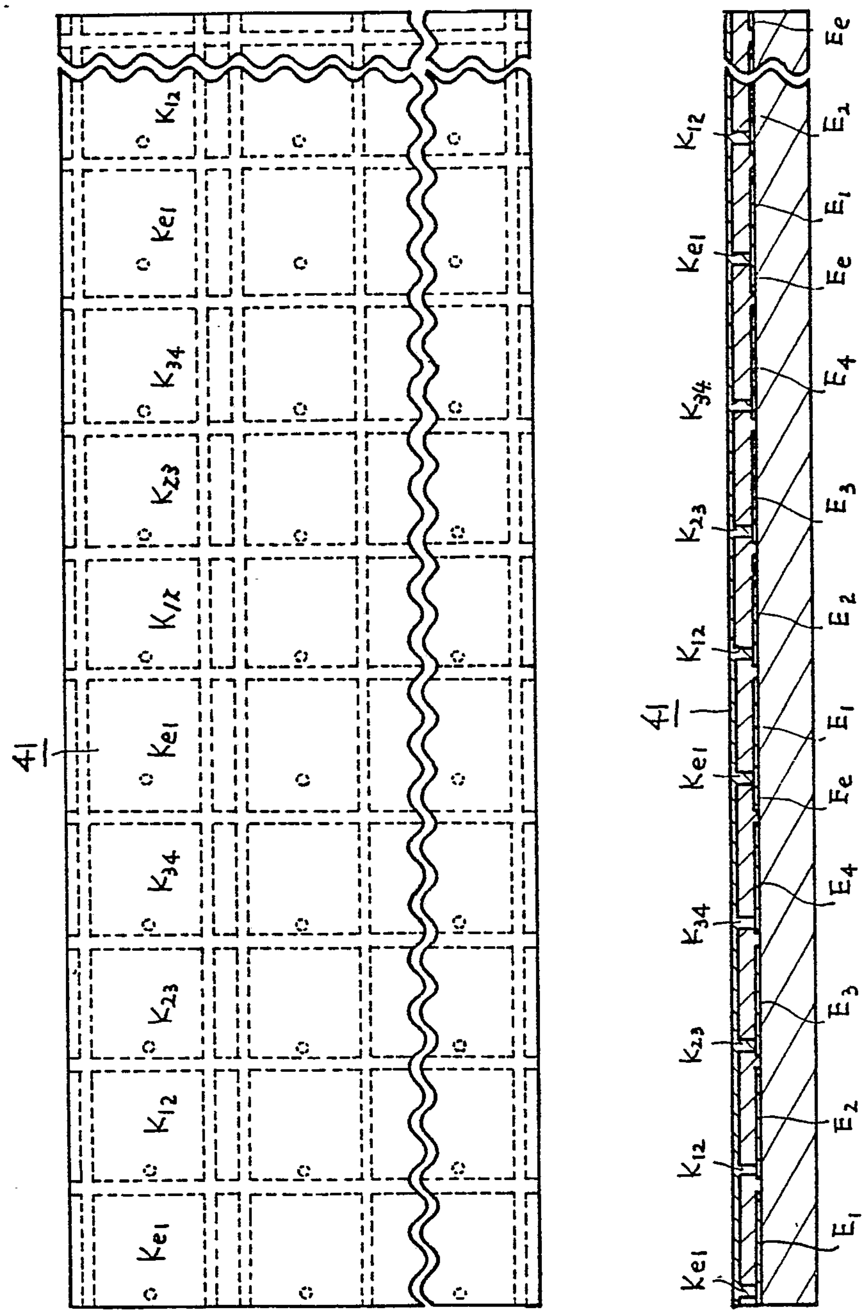


A

B

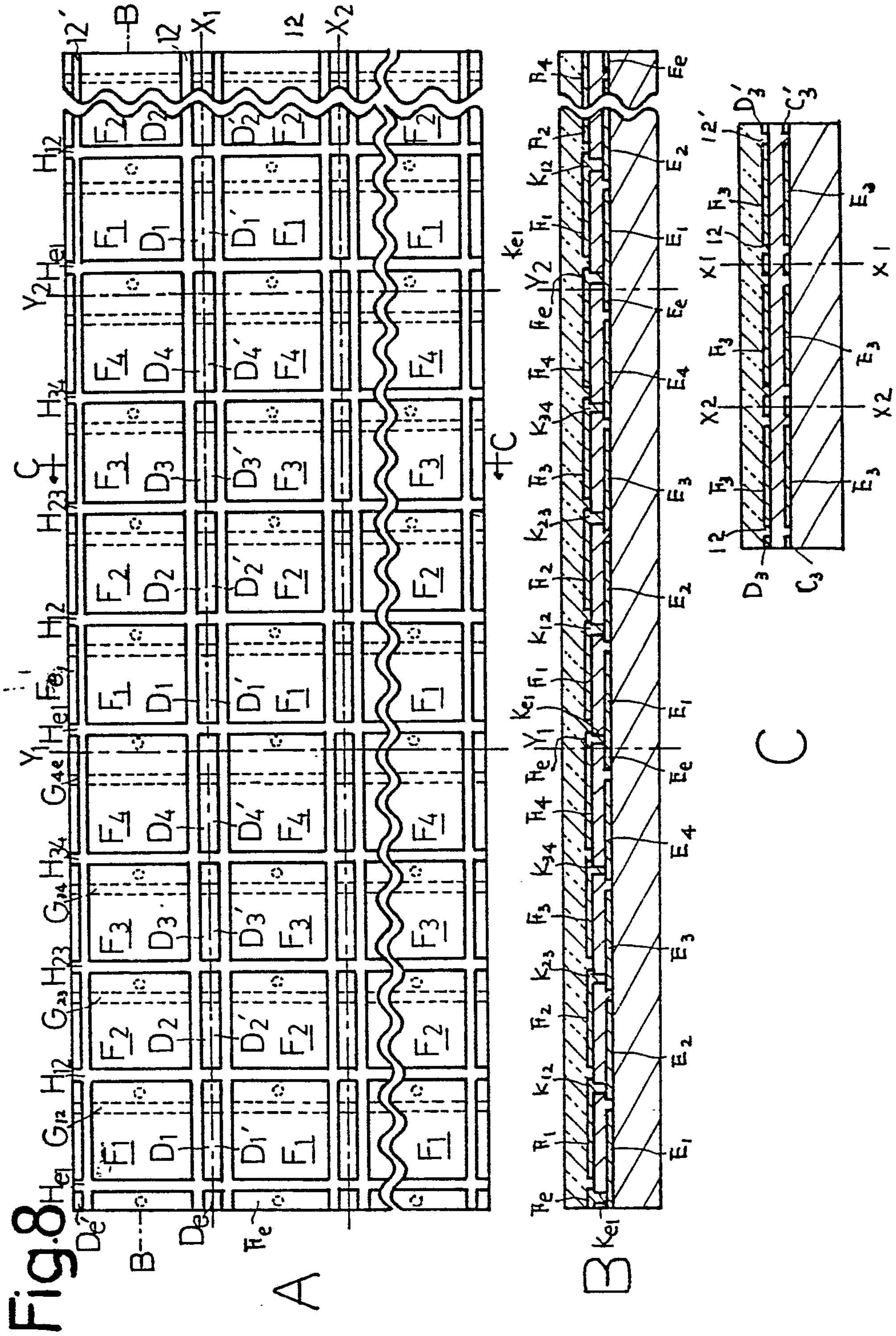


Fig.8

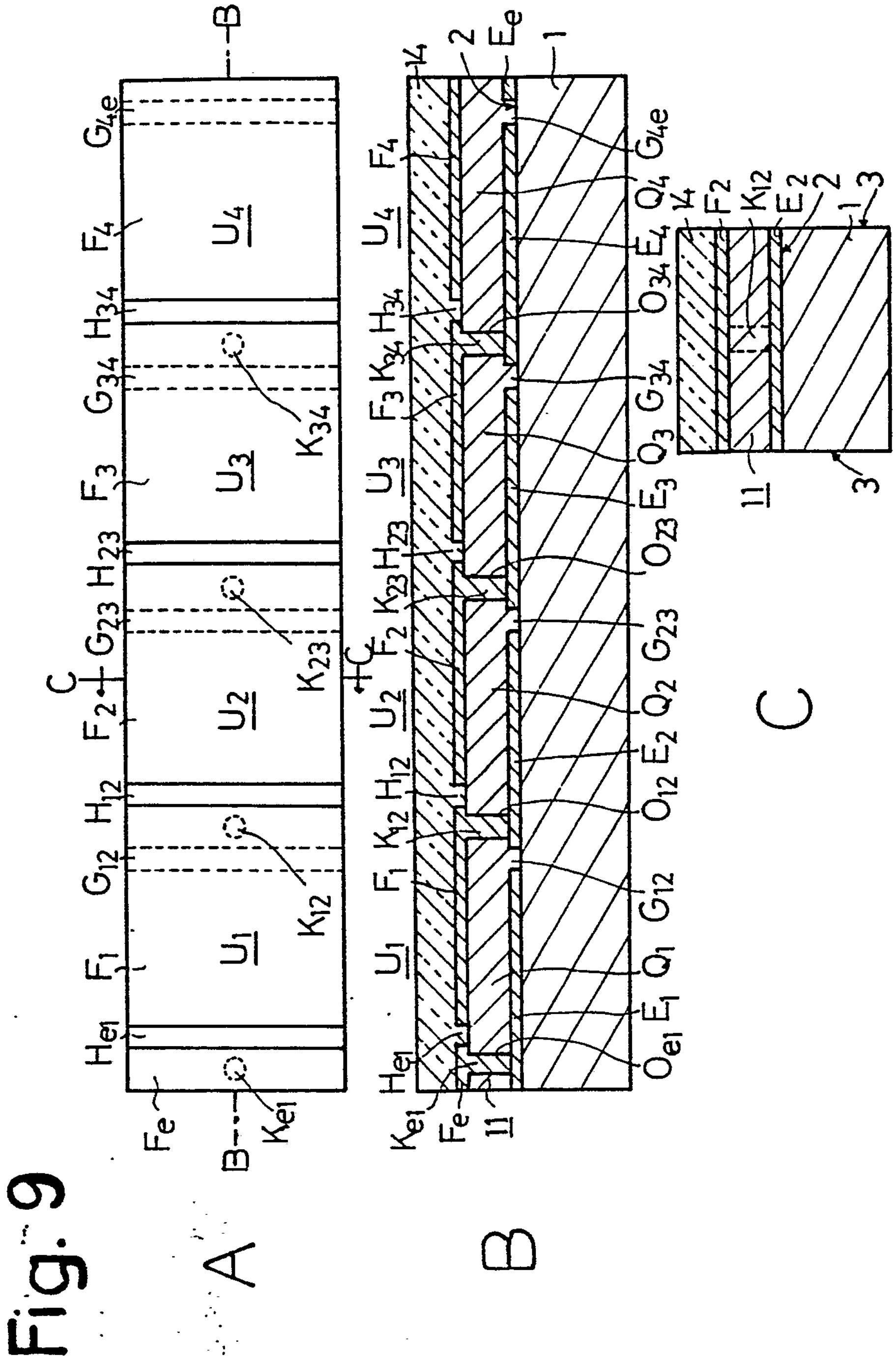
Fig. 9
A
B
C